# EUROPEAN PATENT APPLICATION

(11) **EP 1 467 386 A2**
(43) Date of publication of application: **13.10.2004**
(21) Application number: 04252141.9
(22) Date of filing: 13.04.2004
(51) Int. Cl.: H01G 9/20, H01L 51/30

(54) **Photoelectric conversion device fabrication method, photoelectric conversion device**

(30) Priority: 11.04.2003 JP 2003108076; 11.04.2003 JP 2003108075
(71) Applicant: SONY CORPORATION, Tokyo (JP)
(72) Inventor: Enomoto, Masashi, Shinagawa-ku Tokyo (JP); Honda, Toshio, Shinagawa-Ku Tokyo (JP)
(74) Representative: Sexton, Jane Helen

(57) **Abstract**

In respect to a photoelectric conversion device comprising a semiconductor electrode composed of semiconductor fine particles and a metal film to be an opposite electrode, a polyethylene dioxythiophene (PEDOT)/polystyrenesulfonic acid (PSS) film is formed by spin coating on a transparent electrode of a metal oxide such as ITO to remarkably improve the adhesion property of the metal film to the metal oxide film. Pollution by the different type metal of the metal film to be the opposite electrode can be prevented in the photoelectric conversion device.

Further, a semiconductor electrode composed of semiconductor fine particles can be formed well on the metal oxide film by a low temperature process while elution of the metal oxide film is prevented to obtain the photoelectric conversion device.

## Description

### BACKGROUND OF THE INVENTION

### Field of the Invention

The invention relates to a photoelectric conversion device fabrication method, a photoelectric conversion device, an electronic apparatus manufacturing method, an electronic apparatus, a metal film formation method and its layer structure, and a semiconductor fine particle layer and its layer structure and particularly to those suitable for application to a wet type solar cell comprising a semiconductor electrode of semiconductor fine particles.

### Description of the Related Arts

A dye-sensitized solar cell comprising a semiconductor with a high band gap sensitized by a dye is an economical solar cell of great promise in place of a conventional solar cell comprising silicon or a compound semiconductor and today it has enthusiastically been investigated (Nature, 353 (1991) 737).

Investigations have been carried out so far mainly focusing on the improvement of the cell efficiency to the maximum extent. According to the recent investigation by Graztel et al. , 10% energy conversion efficiency is reported (J. Am. Chem. Soc., 114 (1993) 6382).

To achieve a high efficiency, it is required to sufficiently absorb light energy and therefore, a porous film comprising semiconductor fine particles in nano-scale is used for enlarging the semiconductor surface to absorb a dye therein. Presently, anatase type titanium oxide is widely used as a semiconductor.

The general structure of the dye-sensitized solar cell is composed of a semiconductor fine particle layer containing titanium oxide and the like on a transparent conductive substrate, a combination of a semiconductor electrode and an opposite electrode comprising a platinum film further thereon, and an organic electrolytic solution containing redox species such as iodine and iodide ion packed between both electrodes. The platinum film as the opposite electrode is generally formed on a transparent electrode of a metal oxide such as indium (In)-tin (Sn) oxide (ITO) by a sputtering method or the like.

In order to improve the energy efficiency, electric contact among these fine particles has to be sufficient and high temperature treatment (about 450°C) by firing is required. The necessity of the firing process is a serious problem to be overcome for producing a flexible solar cell. That is, most of polymer materials to be used for the film electrode cannot stand such a high temperature.

Recently, investigations have been started to make a solar cell portable and flexible so as to widen the utilization sites and convenience in such a manner that the solar cell is stuck to a wall or a window. As conventional methods, there have been the following methods; an electrode position method carried out by applying an electric field to an ITO (indium-tin oxide) electrode using a dispersion obtained by dispersing titanium oxide in an organic solvent (Chem. Lett. 12 (2002) 1250), a press bonding method carried out by applying pressure to a cast titanium oxide fine particle film (Nano Lett. 2 (2001) 97), and a method carried out by applying a water-alcohol dispersion containing TiCl₄, TiOSO₄, or Ti (O-iPr) ₄ as a raw material for titanium oxide and then heating the raw material coating at 100°C for 24 hours in an autoclave (Chem. Lett. 9 (2002) 874). However, these methods require an electrode position apparatus, a large scale press apparatus, and a large scale autoclave, respectively and thus have a problem of productivity.

Meanwhile, it is reported that when a titanium oxide colloidal solution containing no surfactant is applied, a good film can be formed by drying at a temperature of 100°C (Langmuir, 16 (2000) 5625). According to the method, it is supposed to be possible to form a titanium oxide fine particle layer on a film electrode of a polymer material.

In addition, transparent conductive materials obtained by applying organic conductive polymers and p-type inorganic semiconductors are proposed (Japanese Patent Application Laid-Open No. 2002-93242). Also, as a coating material for a conductive substrate such as ITO, PEDOT/PSS coating is proposed (Japanese Patent Application National Publication Laid-Open No.2002-526801). PEDOT/PSS coating on a glass substrate on which ITO is formed is proposed as well (Japanese Patent Application National Publication Laid-Open No. 2002-508599).

Further, it is reported that when ITO is left for a long time while being wetted with an aqueous PEDOT/PSS solution, ITO is corroded with the acidity of the aqueous PEDOT/PSS solution and indium is therefore diffused in the PEDOT/PSS (Appl. Phys. Lett. 77 (2000) 2255).

However, as described above, when a platinum film is formed on the transparent electrode of a metal oxide such as ITO, owing to extremely inferior adhesion property of the platinum film, there occurs a problem that the film is easily peeled.

In order to prevent such a problem, there is a method for forming the platinum film after a film of tungsten or chromium having a good adhesion property to a transparent electrode of a metal oxide such as ITO is formed on the transparent electrode, however since the underlayer of the platinum film is a film of a different type metal, the platinum film is possibly polluted with the different type metal and that is not preferable.

Accordingly, the purpose of the invention is to provide a photoelectric conversion device fabrication method by which the adhesion property of a metal film of such as platinum to be an opposite electrode to a metal oxide film is remarkably improved and pollution of the metal film to be an opposite electrode with a different type metal is prevented and to provide a photoelectric conversion device.

The purpose of the invention is, more in general, to provide an electronic apparatus manufacturing method by which the adhesion property of a metal film of such as platinum to a metal oxide film is remarkably improved and pollution of the metal film with a different type metal is prevented and to provide an electronic apparatus.

The purpose of the invention is, furthermore in general, to provide a metal film formation method by which the adhesion property of a metal film of such as platinum to a metal oxide film is remarkably improved and pollution of the metal film with a different type metal is prevented and to provide a layer structure.

Further, in Langmuir, 16 (2000) 5625 method, there is a problem that in the case no surfactant is contained, a titanium oxide colloidal solution is stably only in strongly acidic (pH <2) condition and the coating side of an ITO electrode is dissolved in such a condition. Therefore, a fluorine-doped SnO (FTO) electrode excellent in the acid resistance is employed, however it is very difficult to form FTO on a film of a polymer material and as compared with ITO, FTO, in general, has a high electric resistance and is disadvantageous to be used as an electrode of a solar cell. It is supposed to be also possible to use a neutral titanium oxide fine particle dispersion, however in this case, bonding among titanium oxide fine particles is hard to be caused and cross-linking does not take place, so that only an extremely fragile film is obtained and its practical application is very difficult.

Accordingly, the purpose of the invention is to provide a photoelectric conversion device fabrication method by which a semiconductor electrode comprising semiconductor fine particles is formed well on a metal oxide film in low temperature process while elution of the metal oxide film is prevented and to provide a photoelectric conversion device.

The purpose of the invention is, more in general, to provide an electronic apparatus manufacturing method by which a semiconductor electrode comprising semiconductor fine particles is formed well on a metal oxide film in low temperature process while elution of the metal oxide film is prevented and to provide an electronic apparatus.

The purpose of the invention is, furthermore in general, to provide a metal film formation method by which a semiconductor electrode comprising semiconductor fine particles is formed well on a metal oxide film in low temperature process while elution of the metal oxide film is prevented and to provide a layer structure.

Inventors of the invention have made various experiments and investigations so as to solve the above-mentioned problems of conventional techniques and have found that in the case a platinum film is formed on a metal oxide film such as ITO, all of the above-mentioned problems can be solved by forming a film of polyethylene dioxythiophene (PEDOT)/polystyrenesulfonic acid (PSS), conductive polymers, on the metal oxide film and forming a platinum film further thereon. Based on the results of further investigations, in general, same effects can be obtained in the case a film of polythiophene and its derivatives as well as polystyrenesulfonic acid is formed on a metal oxide film and a platinum film is formed thereon.

The invention is accomplished based on the above-mentioned investigations and findings.

### SUMMARY OF THE INVENTION

Inventors of the invention have made various experiments and investigations so as to accomplish the above-mentioned problems of conventional techniques and have found that in the case a platinum film is formed on a metal oxide film such as ITO, all of the above-mentioned problems can be solved by forming a film of polyethylene dioxythiophene (PEDOT)/polystyrenesulfonic acid (PSS), conductive polymers, on the metal oxide film and forming a platinum film further thereon. Based on the results of further investigations, in general, same effects can be obtained in the case a film of polythiophene and its derivatives as well as polystyrenesulfonic acid is formed on a metal oxide film and a platinum film is formed thereon.

The invention is accomplished based on the above-mentioned investigations and findings.

That is, in order to solve the above-mentioned problems, the first invention is a production method of a photoelectric conversion device comprising a semiconductor electrode composed of semiconductor fine particles on a metal oxide film and characterized in that an intermediate film comprising at least one compound selected from polythiophene defined by the following Formula 18 and its derivatives as well as polystyrenesulfonic acid defined by the following Formula 19, RSO₃H (R = an alkyl or an aryl) , R' OSO₃H (R' = H, an alkyl, or an aryl) , HCl, HClO₄, HPF₆, HBF₄, and HI₅ is formed on the metal oxide film and a metal film is formed on the intermediate film:

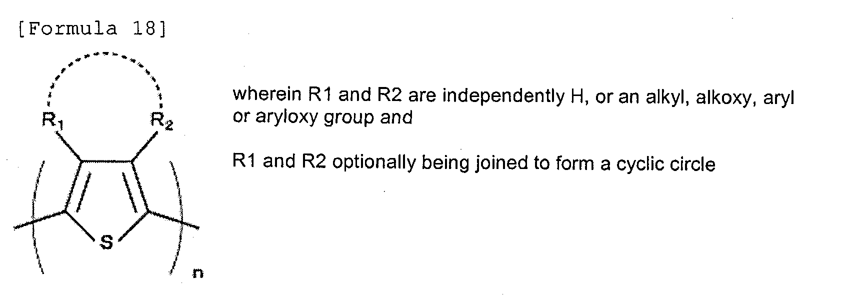

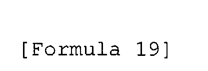

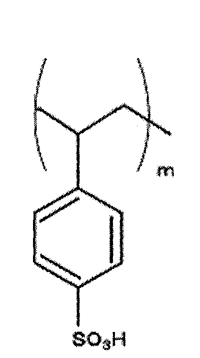

In all the given formulae for polythiophene, each alkyl or alkoxy group preferably has up to 6 carbon atoms, more preferably up to 4 carbon atoms e.g. 1, 2 or 3 carbon atoms. The number of carbon atoms in the alkyl or alkoxy group is preferably less than 10. The aryl group has up to 10 carbon atoms, preferably 6 carbon atoms. The number of carbon atoms in the aryl group is preferably less than 10. Preferably R₁ and R₂ are joined to form a group -O- alkylene -O- where the alkylene group has up to 4 carbon atoms, preferably 1, 2 or 3 carbon atoms, most preferably 2 carbon atoms i.e. -O -CH₂-CH₂-O- .

In all the given formulae m and n are natural numbers and the range of m and n are not limited especially. The preferable molecular weight of polythiophene (PODE) or polystyrenesulfonic (PSS) acid depends on a solution into which the PODE or PSS dissolves, regarding viscocity. M and n are typically such that the molecular weight is preferably less than several millions (for example 2, 3 or 4 million) , more preferably less than a million, more preferably less than several hundred thousands, more preferably less than a hundred thousands and more preferably less than fifty thousands .

The second invention is a photoelectric conversion device comprising a semiconductor electrode and a metal film to be an opposite electrode formed on a metal oxide film and characterized in that an intermediate film comprising at least one compound selected from polythiophene defined by the following Formula 20 and its derivatives as well as polystyrenesulfonic acid defined by the following Formula 21, RSO₃H (R = an alkyl or an aryl) , R' OSO₃H (R' = H, an alkyl, or an aryl), HCl, HClO₄, HPF₆, HBF₄, and HI₅ is formed on the metal oxide film and a metal film is formed on the intermediate film: [Formula 20]

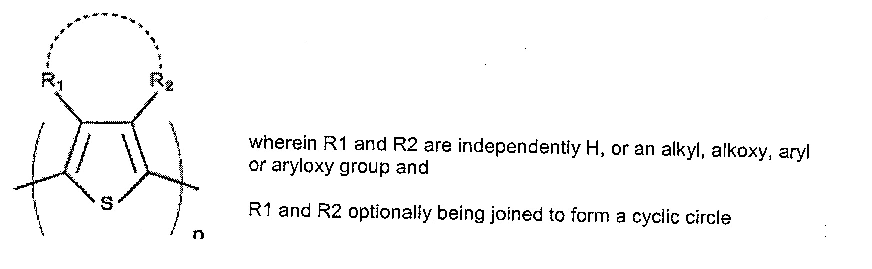

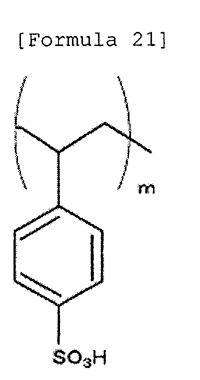

In the first and second inventions, polystyrenesulfonic acid, RSO₃H, R'OSO₃H, HCl, HClO₄, HPF₆, HBF₄, and HI₅ become dopants for polythiophene and its derivatives and a conductive polymer is produced from these compounds.

Most commonly, the intermediate film is composed of polyethylenedioxythiophene defined by the following Formula 22 and polystyrenesulfonic acid defined by the following Formula 23, that is, PEDOT/PSS:

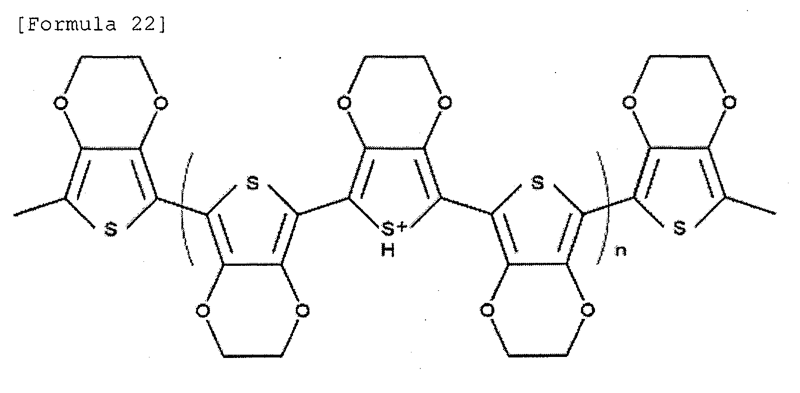

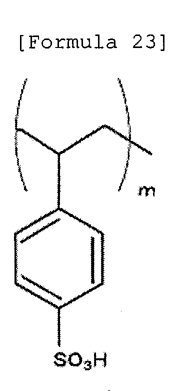

Most commonly, the intermediate film is produced by using an aqueous solution containing polyethylenedioxythiophene defined by the following Formula 24, polystyrenesulfonic acid ion defined by the following Formula 25, and polystyrenesulfonic acid defined by the following Formula 26 and applying the solution to a metal oxide film by spin coating:

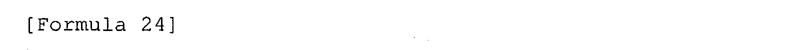

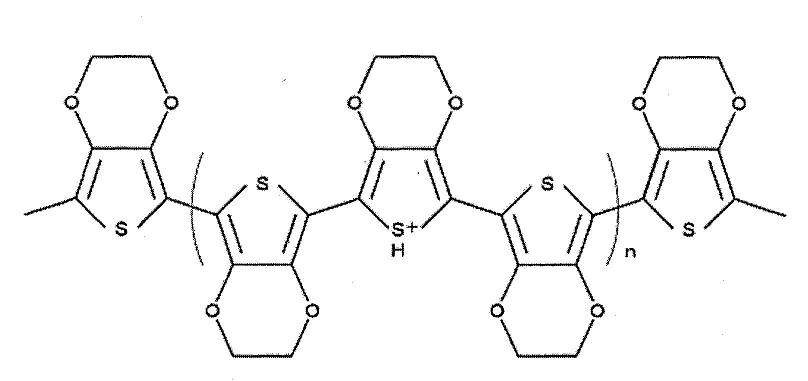

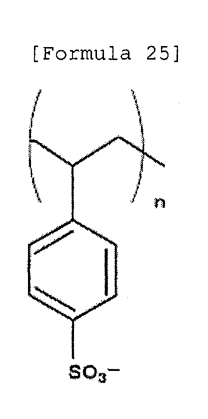

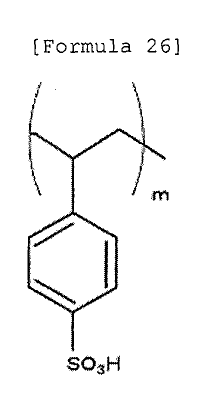

Even if the thickness of the intermediate film is as thin as about several nm, the film can improve the adhesion property to the undercoating metal oxide film and the adhesion property of the metal film to the intermediate film. In order to lessen the instability of the adhesion property because of dispersion of the thickness at the time of film formation and unevenness of the thickness in a plane or to make film formation easy, the thickness is preferably 15 nm or more and 500 nm or less, more preferably 30 nm or more and 400 nm or less.

The metal oxide film is made of, for example, at least one metal oxide selected from an In-Sn oxide, SnO₂ [including fluorine-doped SnO₂ (FTO) ] , TiO₂, and ZnO and it is typically used as a transparent electrode.

The metal oxide film, in general, is formed on a conductive or nonconductive transparent supporting substrate. The material for the transparent supporting substrate is not particularly limited and a variety of base materials can be used if they are transparent and those which are excellent in capability of shutting water and gases penetrating from the outside of a photoelectric conversion device, solvent resistance, and weather resistance are preferable. Examples of the transparent supporting substrate are transparent inorganic substrates of quartz and glass and transparent plastic substrates of poly(ethylene terephthlate), poly(ethylene naphthalate), polycarbonates, polystyrene, polyethylene, polypropylene, polyphenylenesulfide, poly(vinylidene fluoride), tetraacetyl cellulose, phenoxy bromide, aramides, polyimides, polystyrenes, polyallylates, polysulfones, polyolefins and the like, however it is not limited to these examples. In consideration of processibility and light weight, a transparent plastic substrate of such as poly(ethylene terephthalate) is preferably used as the transparent supporting substrate. The thickness of the transparent supporting substrate is not particularly limited and can be selected optionally depending on the light transmittance and the shutting property between the inside and the outside of the photoelectric conversion device.

The metal film is made of at least one metal selected from, for example, platinum, gold, aluminum, silver, and titanium and in general, it is composed of a single layer film or a multi-layer film of these metals.

The semiconductor electrode is, in general, composed of semiconductor fine particles. A material usable as the semiconductor fine particles may include element semiconductors such as silicon, a variety of compound semiconductors, and compounds with perovskite structure. These semiconductors are preferably n-type semiconductors comprising electrons in the conduction band to be a carrier in light excitation condition and giving anode electric current. Practically, these semiconductors may include, for example, TiO₂, ZnO, WO₃, Nb₂O₅, TiSrO₃, and SnO₂ and among them, TiO₂, especially, anatase type TiO₂, is particularly preferable in terms of photocatalytic activity. The anatase type TiO₂ may be in form of a commercialized powder, sol, a slurry, or a particle with a prescribed particle diameter produced by a known method of hydrolyzing a titanium oxide alkoxide. The types of the semiconductors are not particularly limited to the examples and two or more kinds of these semiconductors may be used in combination.

The particle size of the semiconductor fine particles is not particularly limited and is preferably 1 to 200 nm on the basis of the average particle diameter of primary particles and further preferably 5 to 100 nm. It is also possible to mix semiconductor fine particles with an average particle diameter in the defined range with semiconductor fine particles with an average particle diameter larger than that of the former so as to scatter the coming-in light rays by the semiconductor fine particles with a larger average particle diameter and thereby increase the quantum yield. In such a case, the average particle diameter of the semiconductor fine particles to be mixed additionally is preferably 20 to 500 nm.

A formation method of the semiconductor electrode composed of the semiconductor fine particles is not particularly limited, however, in consideration of physical properties, convenience, and the production cost, a wet type film formation method is preferable and a method involving a step of applying either a dispersion obtained by a powder or sol of semiconductor fine particles in a solvent such as water or a paste obtained by adding a binder further to the dispersion to a transparent conductive substrate. As the transparent conductive substrate, for example, as described above, a conductive or non-conductive transparent supporting substrate coated with a metal oxide film may be used. The application method is not particularly limited and a variety of the following known methods can be employed: a dipping method, a spraying method, a wire bar method, a spin coating method, a roller coating method, a blade coating method, a gravure coating method: and as a wet printing method, a variety of methods such as relief printing, off-set, gravure, intaglio, rubber plate printing, and screen printing can be employed. At the time of using a commercialized powder as the semiconductor fine particles, the secondary agglomerates of the particles are preferably solved by crushing particles by a mortar and a ball mill at the time of producing a coating solution. In that case, to prevent the dissociated particles of the secondary agglomerates from re-agglomeration, it is preferable to add acetylacetone, hydrochloric acid, nitric acid, a surfactant, or a chelating agent. Also, for a purpose of increasing the viscosity, polymers such as polyethylene oxide and polyvinyl alcohol and a variety of thickeners such as cellulose type thickeners may be added.

As a coloring material to be deposited on the semiconductor fine particles, any coloring material may be used without any particular limitation if it has a sensitizing function and preferable examples are Xanthene type coloring materials such as Rhodamine B, Rose Bengal, Eosine, and Erythrosine; Cyanine type coloring materials such as quinocyanine and cryptocyanine; basic dyes such asphenosafranine, CapriBlue, thiosine, Methylene Blue; porphyrin type compounds such as chlorophyll, zinc porphyrin, and magnesium porphyrin; and additionally, azo coloring materials, phthalocyanine compounds, cumarin type compounds, Ru bipyridine complex compounds, anthraquinone type coloring materials, and polycyclic quinone type coloring materials. Among them, ruthenium (Ru) bipyridine complex compounds have high quantum yield and are especially preferable, however the coloring material is not limited to these examples and these exemplified materials may be used alone or in form of a mixture of two or more of them.

A method for depositing the above-mentioned coloring material on the semiconductor fine particle layer is not particularly limited and for example, a method involving dissolving the coloring material in a solvent such as alcohols, nitriles, nitromethane, halogenated hydrocarbons, ethers, dimethyl sulfoxide, amides, N-methylpyrrolidone, 1,3-dimethylimidazolidinone, 3-methyloxazolidinone, esters, carbonic acid esters, ketones, hydrocarbons, and water; and either immersing semiconductor fine particle layer in the resulting coloring material solution or applying the solution to the semiconductor fine particle layer is generally employed. In this case, the loading amount of the coloring material to a single semiconductor fine particle is preferably 1 to 1,000 molecules and further preferably 1 to 100 molecules. If an excess amount of the coloring material molecules are deposited on the semiconductor fine particles, the electrons excited by light energy are not injected into the semiconductor fine particles and subsequently reduce the electrolytic substances to result in energy loss. Accordingly, it is ideal that the coloring material molecules are kept in a monomolecular adsorption state in relation to the respectively semiconductor fine particles and based on necessity, the deposition temperature and pressure can be changed. In order to lessen the association of the coloring material particles one another, carboxylic acids such as deoxycholic acid may be added. Also, UV absorbents may be used in combination.

For the purpose of promoting removal of the excess amount of the adsorbed coloring material, the surface treatment of the semiconductor fine particles may be carried out using amines after the coloring material adsorption. Examples of the amines are pyridine, 4-tert-butylpyridine, and polyvinylpyridine and they may be used as they are if they are in liquid state or being dissolved in an organic solvent.

The electrolytic substance may be combinations of iodine (I₂) with metal iodides or organic iodine compounds; combinations of bromine (Br₂) with metal bromides or organic bromine compounds; metal complexes such as ferrocyanic acid salt/ferricyanic acid and ferrocene/ferricinium ion; sulfur compounds such as polysodium sulfide and alkylthiol/alkyl disulfide; viologen dyes, and hydroquinone/quinone. Cations of the above-mentioned metal compounds may be Li, Na, K, Mg, Ca, and Cs and preferable examples of the cations of the above-mentioned organic compounds may be quaternary ammonium compounds such as tetraalkylammoniums, pyridiniums, and imidazoliums, however they are not limited to these examples and these exemplified compounds may be used in form of a mixture of two or more of them. Among them, electrolytic substances of combinations of I₂ with LiI, NaI and quaternary ammonium compounds such as imidazolium iodide are preferable. The concentration of the electrolytic salts in a solvent is preferably 0.05 to 5 M and more preferably 0.2 to 1 M. The concentration of I₂ or Br₂ is preferably 0.0005 to 1 M and more preferably 0.001 to 0.1 M. Further, in order to improve the open circuit voltage and short-circuit current, a variety of additives such as 4-tert-butylpyridine and carboxylic acid may be added.

Examples of the solvent composing the above-mentioned electrolytic composition may include water, alcohols, ethers, esters, carbonic acid esters, lactones, carboxylic acid esters, phosphoric acid triesters, heterocyclic compounds, nitriles, ketones, amides, nitromethane, halogenated hydrocarbons, dimethyl sulfoxide, sulfurane, N-methylpyrrolidone, 1,3-dimethylimidazolidinone, 3-methyloxazolidinone, and hydrocarbons, however they are not limited to these examples and may be used alone or in form of a mixture of two or more of them. As a solvent, an ionic liquid at a room temperature of such as tetraalkyl type, pyridinium type, or imidazolium type quaternary ammonium compounds may also be used.

In order to suppress the liquid leakage and electrolytic substance evaporation of a photoelectric conversion device, the above-mentioned electrolytic composition may be used in form of a gel state electrolyte by dissolving a gelling agent, a polymer, or a cross-linking monomer therein. With respect to the ratio of the gel matrix and the electrolytic composition, if the content of the electrolytic composition is high, the ion conductivity is high, however the mechanical strength is lowered. On the contrary, if the content of the electrolytic composition is so low, the mechanical strength is high, however the ion conductivity is lowered, so that the ratio of the electrolytic composition is preferably 50 to 99wt%, more preferably 80 to 97wt%, in the gel state electrolyte. Further, it is also possible to obtain a full solid-state photoelectric conversion device by dissolving the above-mentioned electrolytic substance and a plasticizer in a polymer and evaporating and removing the plasticizer.

A photoelectric conversion device fabrication method is not particularly limited and it is possible, for example, that in the case the electrolytic composition is either liquid or to become gel in the inside of a photoelectric conversion device from the liquid state before introduction, a semiconductor electrode carrying a dye and an opposite electrode are set face to face each other and the substrate part where the semiconductor electrode is not formed is sealed so as to keep these electrodes from each other. The sealing method is not particularly limited, a material having light fastness, insulating property, and moisture-proofness is preferable and a variety of welding methods, epoxy resins, UV curable resins, acrylic resins, EVA (ethylene vinyl acetate), ionomer resins, ceramics, thermofusible films and the like can be used. Further, an injection port for injecting a solution of the electrolytic composition is needed, and unless it is above the semiconductor electrode carrying the dye or the opposite electrode facing to the electrode, the position of the injection port is not particularly limited. An injection method is not particularly limited, however a method for injecting a solution in the inside of the above-mentioned cell which is previously sealed and provided with a solution injection port is preferable. In this case, a method carried out by dropwise titrating several droplets of the solution into the inj ection port and then inj ecting the solution based on the capillarity is easy. Further, if necessary, the solution injection may be carried out in reduced pressure or under heating condition. After the solution injection is completed, the solution remaining in the injection port is removed and the injection port is sealed. A method for the sealing is not particularly limited, and based on the necessity, the sealing may be carried out by sticking a glass plate or a plastic substrate with a sealing agent. Further, in the case of a gel state electrolyte using a polymer or a full solid-state electrolyte, the polymer solution containing the electrolytic composition and the plasticizer is evaporated and removed from the semiconductor electrode carrying the dye by a casting method: and after complete removal of the plasticizer, sealing is carried out in the same manner as described above. The sealing is preferably carried out by using a vacuum sealer in an inert gas atmosphere or in a reduced pressure. After the sealing, in order to sufficiently impregnate the semiconductor electrode with the electrolyte, heating or pressurizing step may be carried out based on necessity.

The photoelectric conversion device may be formed into a variety of shapes depending on its use and the shapes are not particularly limited.

The photoelectric conversion device is most generally a dye-sensitized type wet photoelectric conversion device (particularly, a dye-sensitized solar cell).

The above-mentioned method involving steps of forming an intermediate film just as described above on a metal oxide film and forming a metal film of such as platinum on the intermediate film can be employed not only for the photoelectric conversion device but also similarly for any electronic apparatus requiring formation of metal film of such as platinum on a metal oxide film or for the case of forming a metal film of such as platinum on a metal oxide film.

Therefore, the third invention is a method for manufacturing an electronic apparatus comprising a metal film on a metal oxide film and characterized in that the metal film is formed by at first forming an intermediate film comprising at least one compound selected from polythiophene defined by the following Formula 27 and its derivatives as well as polystyrenesulfonic acid defined by the following Formula 28, RSO₃H (R = an alkyl or an aryl) , R' OSO₃H (R' = H, an alkyl, or an aryl), HCl, HClO₄, HPF₆, HBF₄, and HI₅ on the metal oxide film and then forming the metal film on the intermediate film:

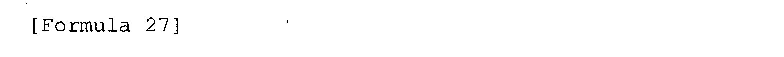

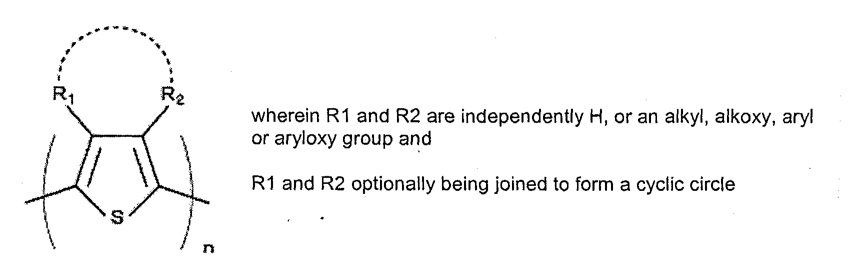

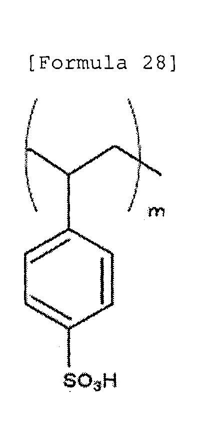

The fourth invention is an electronic apparatus comprising a metal film formed on a metal oxide film and characterized in that the metal film is formed by at first forming an intermediate film comprising at least one compound selected from polythiophene defined by the following Formula 29 and its derivatives as well as polystyrenesulfonic acid defined by the following Formula 30, RSO₃H (R = an alkyl or an aryl), R'OSO₃H (R' = H, an alkyl, or an aryl) , HCl, HClO₄, HPF₆, HBF₄, and HI₅ on the metal oxide film and then forming the metal film on the intermediate film:

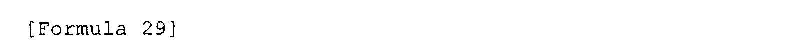

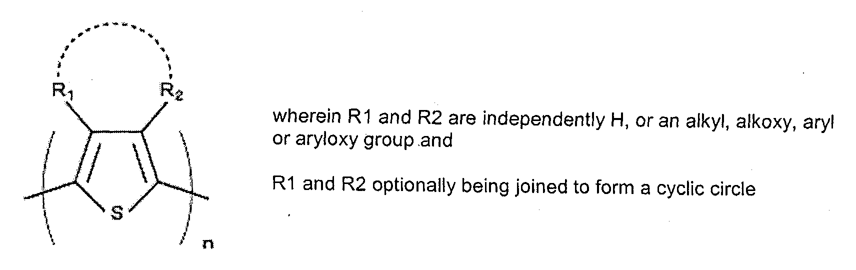

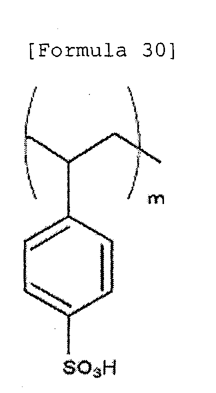

The fifth invention is a metal film formation method for forming a metal film on a metal oxide film comprising steps of at first forming an intermediate film comprising at least one compound selected from polythiophene defined by the following Formula 31 and its derivatives as well as polystyrenesulfonic acid defined by the following Formula 32, RSO₃H (R = an alkyl or an aryl) , R'OSO₃H (R' = H, an alkyl, or an aryl) , HCl, HClO₄, HPF₆, HBF₄, and HI₅ on the metal oxide film and then forming the metal film on the intermediate film:

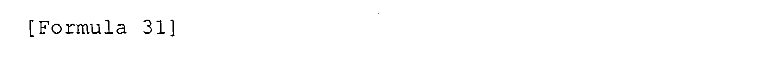

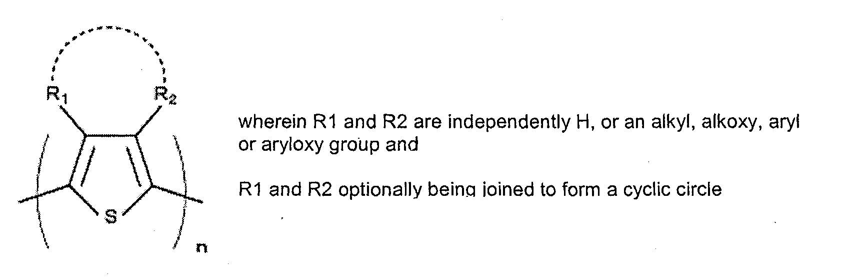

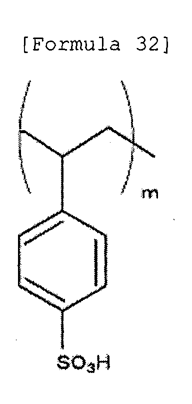

The sixth invention is a layer structure comprising a metal film formed on a metal oxide film and characterized in that an intermediate film comprising at least one compound selected from polythiophene defined by the following Formula 33 and its derivatives as well as polystyrenesulfonic acid defined by the following Formula 34, RSO₃H (R = an alkyl or an aryl), R'OSO₃H (R' = H, an alkyl, or an aryl) , HCl, HClO₄, HPF₆, HBF₄, and HI₅ is formed on the metal oxide film and the metal film is formed on the intermediate film:

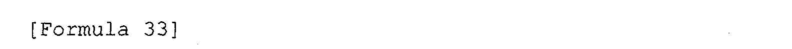

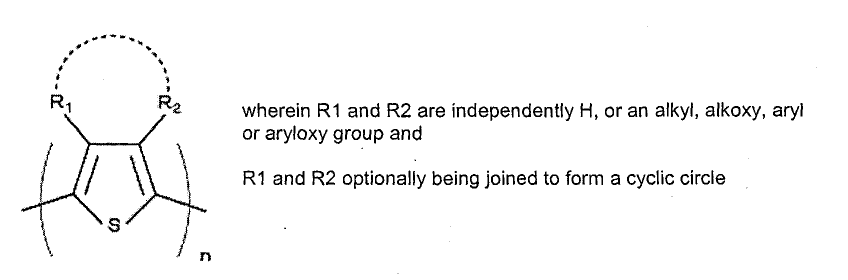

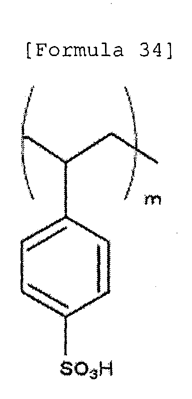

The above-described matters relevant to the first and the second inventions are also the same in the third to the sixth inventions if they are in the scope of the appended claims. The electronic apparatus includes a variety of semiconductor devices other than the photoelectric conversion device and depending on the use and function, it does not comprise any semiconductor electrode in some cases.

According to the inventions constituted as described above, since an intermediate film comprising polythiophene, its derivatives as well as polystyrenesulfonic acid and the like is formed on a metal oxide film and then a metal film of such as platinum is formed on the intermediate film, the adhesion property of the intermediate film to the metal oxide film and the adhesion property of the metal film of such as platinum to the intermediate film are both extremely good and therefore, as compared with that in the case of forming the metal film directly on the metal oxide film, the adhesion property of the metal film can remarkably be improved. Further, different from the case of using a film of tungsten or chromium for adhesion property improvement, there occurs no pollution of the metal film with different kinds of metals.

Inventors of the invention have made various experiments and investigations so as to solve the above-mentioned problems of conventional techniques and have found that in the case a semiconductor fine particle layer such as a titanium oxide fine particle layer is formed on a metal oxide film such as ITO, all of the above-mentioned problems can be solved by at first forming a film of polyethylene dioxythiophene (PEDOT)/polystyrene sulfonic acid (PSS), water-soluble conductive polymers (p-type semiconductor), on the metal oxide film and forming the semiconductor fine particle layer such as the titanium oxide fine particle layer further thereon by using a semiconductor fine particle dispersion such as a titanium oxide fine particle dispersion. Based on the results of further investigations, in general, same effects can be obtained in the case a film of polythiophene and its derivatives as well as polystyrenesulfonic acid is formed on the metal oxide film and the semiconductor fine particle layer such as the titanium oxide fine particle layer is formed thereon.

The invention is accomplished based on the above-mentioned investigations and findings.

That is, in order to solve the above-mentioned problems, the seventh invention is a fabrication method of a photoelectric conversion device comprising a semiconductor electrode composed of semiconductor fine particles on a metal oxide film and characterized in that the method involves steps of forming an intermediate film comprising at least one compound selected from polythiophene defined by the following Formula 35 and its derivatives as well as polystyrene sulfonic acid defined by the following Formula 36, RSO₃H (R = an alkyl or an aryl), R'OSO₃H (R' = H, an alkyl, or an aryl), HCl, HClO₄, HPF₆, HBF₄, and HI₅ on the metal oxide film and then forming a metal film on the intermediate film:

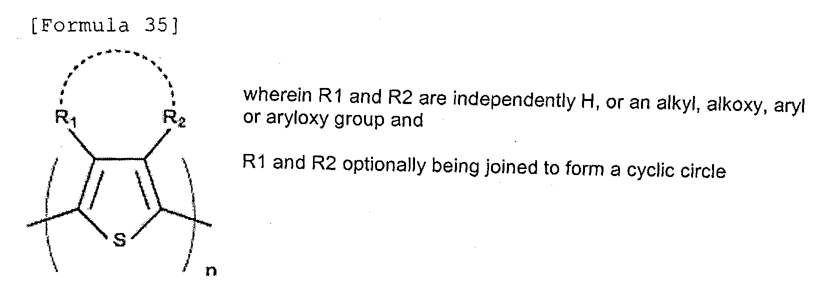

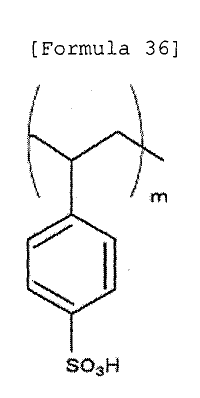

The ninth invention is a photoelectric conversion device comprising a semiconductor electrode composed of semiconductor fine particles on a metal oxide film and characterized in that an intermediate film comprising at least one compound selected from polythiophene defined by the following Formula 35 and its derivatives as well as polystyrenesulfonic acid defined by the following Formula 36, RSO₃H (R = an alkyl or an aryl), R'OSO₃H (R' = H, an alkyl, or an aryl), HCl, HClO₄, HPF₆, HBF₄, and HI₅ is formed on the metal oxide film and a metal film is formed on the intermediate film:

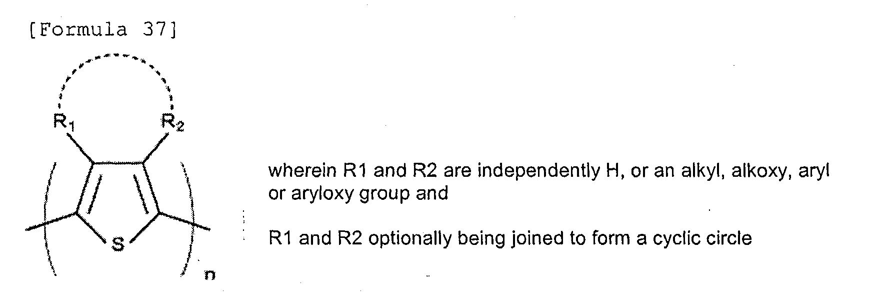

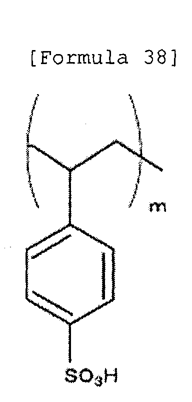

In the eighth and the ninth inventions, polystyrenesulfonic acid, RSO₃H, R'OSO₃H, HCl, HClO₄, HPF₆, HBF₄, and HI₅ become dopants for polythiophene and its derivatives and a conductive polymer is produced from these compounds.

Most commonly, the intermediate film is composed of polyethylenedioxythiophene defined by the following Formula 39 and polystyrenesulfonic acid defined by the following Formula 40, that is, PEDOT/PSS:

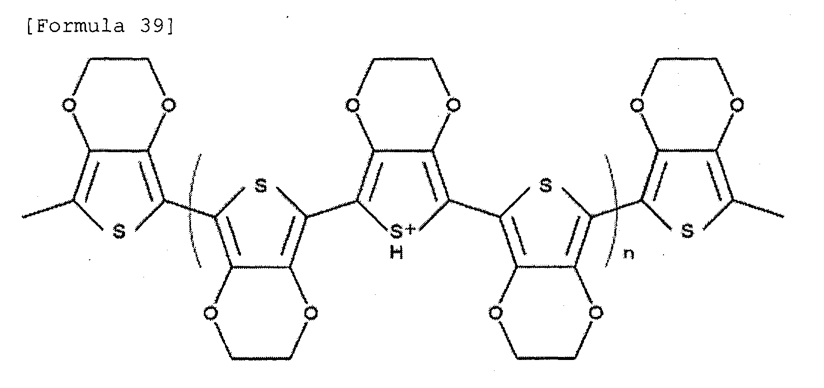

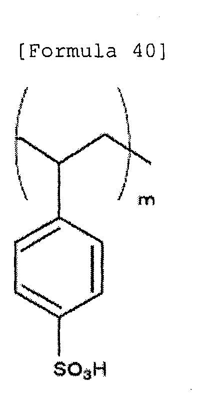

Most commonly, the intermediate film is produced by using an aqueous solution containing polyethylenedioxythiophene defined by the following Formula 41, polystyrenesulfonic acid ion defined by the following Formula 42, and polystyrenesulfonic acid defined by the following Formula 43 and applying the solution to a metal oxide film by spin coating:

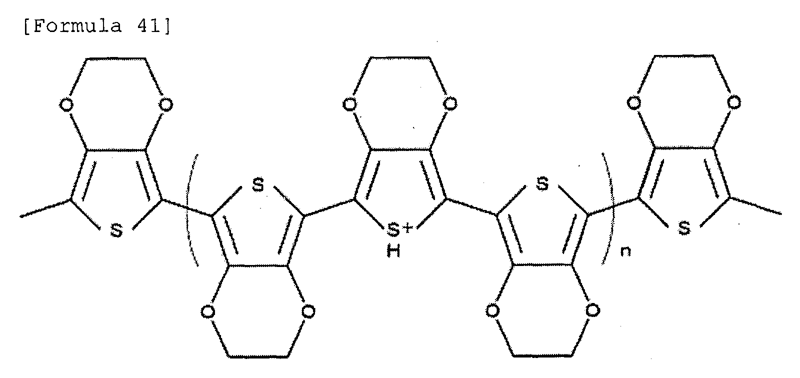

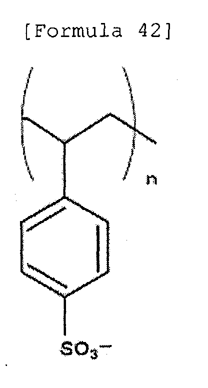

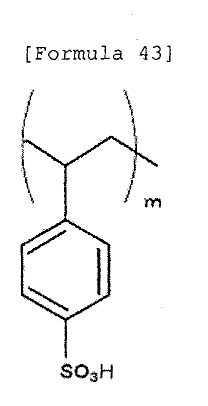

Even if the thickness of the intermediate film is as thin as about several nm, the film can improve the adhesion property to the undercoating metal oxide film and the adhesion property of the semiconductor fine particle layer to the intermediate film. In order to heighten the protection function of the intermediate film for the metal oxide film from a strong acid, the thickness is preferably 15 nm or more, more preferably 30 m or more, and further more preferably 60 nm or more. The upper limit of the thickness of the intermediate film does not particularly exist, however from a view poin to flowering the film formation cost, it is preferably and 500 nm or less, more preferably 400 nm or less. That is, the thickness of the intermediate film is preferably 15 nm or more and 500 nm or less, more preferably 30 m or more and 400 nm or less, and furthermore preferably 60 nm or more and 400 nm or less.

The above-mentioned intermediate film may be used for improving the adhesion property of the metal film such as a platinum film to be an opposite electrode to a semiconductor electrode in connection with a metal oxide film, which is an undercoat layer.

The metal oxide film is made of, for example, at least one metal oxide selected from an In-Sn oxide, SnO₂ [including fluorine-doped SnO₂ (FTO) ] , TiO₂, and ZnO and it is typically used as a transparent electrode.

The metal oxide film, in general, is formed on a conductive or nonconductive transparent supporting substrate. The material for the transparent supporting substrate is not particularly limited and a variety of base materials can be used if they are transparent and those which are excellent in capability of shutting water and gases penetrating from the outside of a photoelectric conversion device, solvent resistance, and weather resistance are preferable. Examples of the transparent supporting substrate are transparent inorganic substrates of quartz and glass and transparent plastic substrates of poly(ethylene terephthlate), poly(ethylene naphthalate), polycarbonates, polystyrene, polyethylene, polypropylene, polyphenylene sulfide, poly(vinylidene fluoride), tetraacetyl cellulose, phenoxy bromide, aramides, polyimides, polystyrenes, polyallylates, polysulfones, polyolefins and the like, however it is not limited to these examples. In consideration of processibility, lightweight, and flexibility, a transparent plastic substrate of such as poly(ethylene terephthalate) is preferably used as the transparent supporting substrate. The thickness of the transparent supporting substrate is not particularly limited and can be selected optionally depending on the light transmittance and the shutting property between the inside and the outside of the photoelectric conversion device.

As materials for the semiconductor fine particles composing the semiconductor electrode, an element semiconductor such as silicon as well as a variety of compound semiconductors and compounds having perovskite structure may be used. These semiconductors are preferably n-type semiconductors comprising electrons in the conduction band to be a carrier in light excitation condition and giving anode electric current. Practically, these semiconductors may include, for example, TiO₂, ZnO, WO₃, Nb₂O₅, TiSrO₃, and SnO₂ and among them, TiO₂, especially, anatase type TiO₂, is particularly preferable in terms of photo catalytic activity. The anatase type TiO₂ may be in form of a commercialized powder, sol, a slurry, or a particle with a prescribed particle diameter produced by a known method of hydrolyzing a titanium oxide alkoxide. The types of the semiconductors are not particularly limited to these examples and two or more kinds of these semiconductors may be used in combination.

The particle size of the semiconductor fine particles is not particularly limited and is preferably 1 to 200 nm on the basis of the average particle diameter of primary particles and further preferably 5 to 100 nm. It is also possible to mix semiconductor fine particles with an average particle diameter in the defined range with semiconductor fine particles with an average particle diameter larger than that of the former so as to scatter the coming-in light rays by the semiconductor fine particles with a larger average particle diameter and thereby increase the quantum yield. In such a case, the average particle diameter of the semiconductor fine particles to be mixed additionally is preferably 20 to 500 nm.

A formation method of the semiconductor electrode composed of the semiconductor fine particles is not particularly limited, however, in consideration of physical properties, convenience, and the production cost, a wet type film formation method is preferable and a method involving a step of applying a dispersion obtained by a powder or sol of semiconductor fine particles in a solvent such as water to a transparent conductive substrate prepared by coating a conductive or non-conductive transparent supporting substrate with a metal oxide film is preferable. The application method is not particularly limited and a variety of the following known methods can be employed: a spin coating method, a roller coating method, a dipping method, a spraying method, a wire bar method, a blade coating method, a gravure coating method: and as a wet printing method, a variety of methods such as relief printing, off-set, gravure, intaglio, rubber plate printing, and screen printing can be employed. At the time of using a commercialized powder as the semiconductor fine particles, the secondary agglomerates of the particles are preferably solved by crushing particles by a mortar and a ball mill at the time of producing a coating solution. In that case, to prevent the dissociated particles of the secondary agglomerates from re-agglomeration, it is preferable to add acetylacetone, hydrochloric acid, nitric acid, a surfactant, or a chelating agent. Also, for a purpose of increasing the viscosity, polymers such as polyethylene oxide and polyvinyl alcohol and a variety of thickeners such as cellulose type thickeners may be added.

As a coloring material to be deposited on the semiconductor fine particles, any coloring material may be used without any particular limitation if it has a sensitizing function and preferable examples are Xanthene type coloring materials such as Rhodamine B, Rose Bengal, Eosine, and Erythrosine; Cyanine type coloring materials such as quinocyanine and cryptocyanine; basic dyes such as phenosafranine,Capri Blue, thiosine, Methylene Blue; porphyrin type compounds such as chlorophyll, zinc porphyrin, and magnesium porphyrin; and additionally, azo coloring materials, phthalocyanine compounds, cumarin type compounds, Ru bipyridine complex compounds, anthraquinone type coloring materials, and polycyclic quinone type coloring materials. Among them, ruthenium (Ru) bipyridine complex compounds have high quantum yield and are especially preferable, however the coloring material is not limited to these examples and these exemplified materials may be used alone or in form of a mixture of two or more of them.

A method for depositing the above-mentioned coloring material on the semiconductor fine particle layer is not particularly limited and for example, a method involving dissolving the coloring material in a solvent such as alcohols, nitriles, nitromethane, halogenated hydrocarbons, ethers, dimethyl sulfoxide, amides, N-methylpyrrolidone, 1,3-dimethylimidazolidinone, 3-methyloxazolidinone, esters, carbonic acid esters, ketones, hydrocarbons, and water; and either immersing semiconductor fine particle layer in the resulting coloring material solution or applying the solution to the semiconductor fine particle layer is generally employed. In this case, the loading amount of the coloring material to a single semiconductor fine particle is preferably 1 to 1,000 molecules and further preferably 1 to 100 molecules. If an excess amount of the coloring material molecules are deposited on the semiconductor fine particles, the electrons excited by light energy are not injected into the semiconductor fine particles and subsequently reduce the electrolytic substances to resultin energy loss. Accordingly, it is ideal that the coloring material molecules are kept in a monomolecular adsorption state in relation to the respectively semiconductor fine particles and based on necessity, the deposition temperature and pressure can be changed. In order to lessen the association of the coloring material particles one another, carboxylic acids such as deoxycholic acid may be added. Also, UV absorbents may be used in combination.

For the purpose of promoting removal of the excess amount of the adsorbed coloring material, the surface treatment of the semiconductor fine particle layer may be carried out using amines after the coloring material adsorption. Examples of the amines are pyridine, 4-tert-butylpyridine, and polyvinylpyridine and they may be used as they are if they are in liquid state or being dissolved in an organic solvent.

A material may be used for the opposite electrode if it is a conductive material and even an insulating substance may be used if a conductive layer is formed in the side facing to the semiconductor electrode. However, an electrochemically stable material is preferable to use as the electrode material and practically, platinum, gold, a conductive polymer, and carbon are preferably used. Further, in order to improve the redox catalytic effect, it is preferable for the side facing to the semiconductor layer to have a fine structure and an increased surface area and for example, in the case of platinum, platinum black state is desirable and also in the case of carbon, porous carbon state is desirable. The platinum black state may be produced by anodization of platinum or treatment with chloroplatinic acid and the porous carbon may be produced by sintering carbon fine particles or firing an organic polymer.

The electrolytic substance may be combinations of iodine (I₂) with metal iodides or organic iodine compounds and combinations of bromine (Br₂) with metal bromides or organic bromine compounds and in addition to these combinations, metal complexes such as ferrocyanic acid salt/ferricyanic acid and ferrocene/ferricinium ion; sulfur compounds such as polysodium sulfide and alkylthiol/alkyl disulfide; viologen dyes, and hydroquinone/quinone can be used. Cations of the above-mentioned metal compounds may be Li, Na, K, Mg, Ca, and Cs and preferable examples of the cations of the above-mentioned organic compounds may be quaternary ammonium compounds such as tetraalkylammoniums, pyridiniums, and imidazoliums, however they are not limited to these examples and these exemplified compounds may be used in form of a mixture of two or more of them. Among them, electrolytic substances of combinations of I₂ with LiI, NaI and quaternary ammonium compounds such as imidazolium iodide are preferable. The concentration of the electrolytic salts in a solvent is preferably 0.05 to 5 M and more preferably 0.2 to 1 M. The concentration of I₂ or Br₂ is preferably 0.0005 to 1 M and more preferably 0.001 to 0.1 M. Further, in order to improve the open circuit voltage and short-circuit current, a variety of additives such as 4-tert-butylpyridine and carboxylic acid may be added.

Examples of the solvent composing the above-mentioned electrolytic composition may include water, alcohols, ethers, esters, carbonic acid esters, lactones, carboxylic acid esters, phosphoric acid triesters, heterocyclic compounds, nitriles, ketones,amides,nitromethane,halogenated hydrocarbons,dimethyl sulfoxide, sulfurane, N-methylpyrrolidone, 1,3-dimethylimidazolidinone, 3-methyloxazolidinone, and hydrocarbons, however they are not limited to these examples and may be used alone or in form of a mixture of two or more of them. As a solvent, an ionic liquid at a room temperature of such as tetraalkyl type, pyridinium type, or imidazolium type quaternary ammonium compounds may also be used.

In order to suppress the liquid leakage and electrolytic substance evaporation of a photoelectric conversion device, the above-mentioned electrolytic composition may be used in form of a gel state electrolyte by dissolving a gelling agent, a polymer, or a cross-linking monomer therein. With respect to the ratio of the gel matrix and the electrolytic composition, if the content of the electrolytic composition is high, the ion conductivity is high,however the mechanical strength is lowered. On the contrary, if the content of the electrolytic composition is so low, the mechanical strength is high, however the ion conductivity is lowered, so that the ratio of the electrolytic composition is preferably 50 to 99 wt%, more preferably 80 to 97 wt%, in the gel state electrolyte. Further, it is also possible to obtain a full solid-state photoelectric conversion device by dissolving the above-mentioned electrolytic substance and a plasticizer in a polymer and evaporating and removing the plasticizer.

A photoelectric conversion device fabrication method is not particularly limited and it is possible, for example, that in the case the electrolytic composition is either liquid or to become gel in the inside of a photoelectric conversion device from the liquid state before introduction, a semiconductor electrode carrying a dye and an opposite electrode are set face to face each other and the substrate part where the semiconductor electrode is not formed is sealed so as to keep these electrodes from each other. The interval between the semiconductor electrode and the opposite electrode is not particularly limited and it is in general 1 to 100 µm and preferably 1 to 50 µm. If the interval between the electrodes is so long, the photoelectric current is decreased because of decrease of conductivity. The sealing method is not particularly limited, a material having light fastness, insulating property, and moisture-proofness is preferable to use and a variety of welding methods, epoxy resins, UV curable resins, acrylic resins, EVA (ethylene vinyl acetate), ionomer resins, ceramics, thermofusible films and the like can be employed. Further, an injection port for injecting a solution of the electrolytic composition is needed, and unless it is right above the semiconductor electrode carrying the dye or the opposite electrode facing to the former electrode, the position of the injection port is not particularly limited. An injection method is not particularly limited, however a method for injecting a solution in the inside of the above-mentioned cell which is previously sealed and provided with a solution injection port is preferable. In this case, a method carried out by dropwise titrating several droplets of the solution into the injection port and then injecting the solution based on the capillarity is easy. Further, if necessary, the solution injection may be carried out in reduced pressure or under heating condition. After the solution injection is completed, the solution remaining in the injection port is removed and the injection port is sealed. A method for the sealing is not particularly limited, and based on the necessity, the sealing may be carried out by sticking a glass plate or a plastic substrate with a sealing agent. Further, in the case of a gel state electrolyte using a polymer or a full solid-state electrolyte, the polymer solution containing the electrolytic composition and the plasticizer is evaporated and removed from the semiconductor electrode carrying the dye by a casting method: After complete removal of the plasticizer, sealing is carried out in the same manner as described above. The sealing is preferably carried out by using a vacuum sealer in an inert gas atmosphere or in a reduced pressure. After the sealing, in order to sufficiently impregnate the semiconductor fine particle layer with the electrolyte, heating or pressurizing step may be carried out based on necessity.

The photoelectric conversion device may be formed into a variety of shapes depending on its use and the shapes are not particularly limited.

The photoelectric conversion device is most generally a dye-sensitized type wet photoelectric conversion device (particularly, a dye-sensitized solar cell).

The above-mentioned method involving steps of forming an intermediate film just as described above on a metal oxide film and forming a semiconductor electrode composed of semiconductor fine particles on the intermediate film can be employed not only for the photoelectric conversion device but also similarly for any electronic apparatus requiring formation of the semiconductor electrode composed of semiconductor fine particles on a metal oxide film.

Accordingly, the tenth invention is a method for manufacturing an electronic apparatus comprising a semiconductor electrode composed of semiconductor fine particles on a metal oxide film and characterized in that the method involves steps of at first forming an intermediate film comprising at least one compound selected from polythiophene defined by the following Formula 44 and its derivatives as well as polystyrenesulfonic acid defined by the following Formula 45, RSO₃H (R = an alkyl or an aryl) , R' OSO₃H (R' = H, an alkyl, or an aryl), HCl, HClO₄, HPF₆, HBF₄, and HI₅ on the metal oxide film and then forming the semiconductor electrode on the intermediate film:

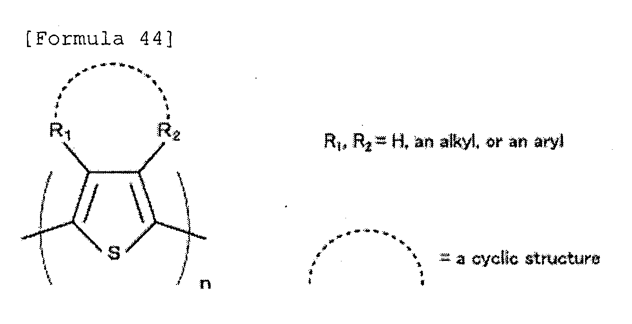

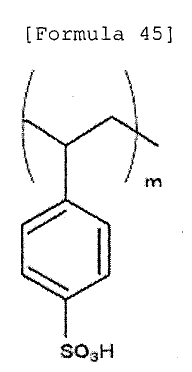

The eleventh invention is an electronic apparatus comprising a semiconductor electrode composed of semiconductor fine particles on a metal oxide film and characterized in that at first an intermediate film comprising at least one compound selected from polythiophene defined by the following Formula 46 and its derivatives as well as polystyrenesulfonic acid defined by the following Formula 47, RSO₃H (R = an alkyl or an aryl), R'OSO₃H (R' = H, an alkyl, or an aryl), HCl, HClO₄, HPF₆, HBF₄, and HI₅ is formed on the metal oxide film and then the semiconductor electrode is formed on the intermediate film:

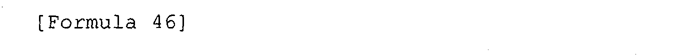

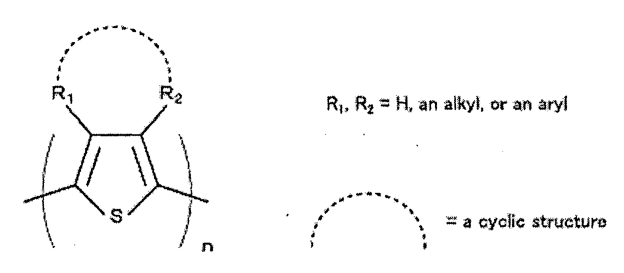

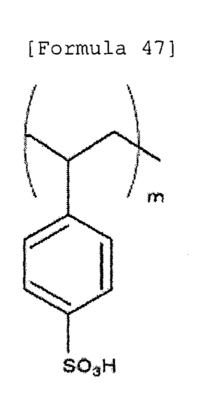

The twelfth invention is a semiconductor fine particle layer formation method for forming a semiconductor fine particle layer on a metal oxide film and characterized in that the method involves steps of at first forming an intermediate film comprising at least one compound selected from polythiophene defined by the following Formula 48 and its derivatives as well as polystyrenesulfonic acid defined by the following Formula 49, RSO₃H (R = an alkyl or an aryl) , R'OSO₃H (R' = H, an alkyl, or an aryl) , HCl, HClO₄, HPF₆, HBF₄ ,and HI₅ on the metal oxide film and then forming the semiconductor fine particle layer on the intermediate film:

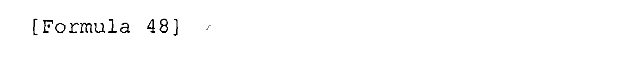

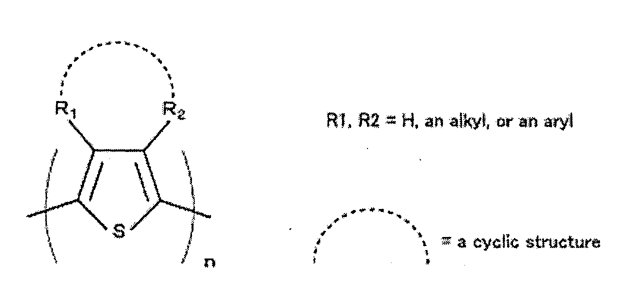

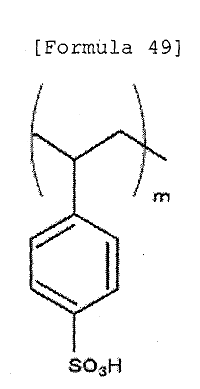

The thirteenth invention is a layer structure comprising a semiconductor fine particle layer formed on a metal oxide film and characterized in that an intermediate film comprising at least one compound selected from polythiophene defined by the following Formula 50 and its derivatives as well as polystyrenesulfonic acid defined by the following Formula 51, RSO₃H (R = an alkyl or an aryl) , R'OSO₃H (R' = H, an alkyl, or an aryl) , HCl, HClO₄, HPF₆, HBF₄, and HI₅ is formed on the metal oxide film and the semiconductor fine particle layer is formed on the intermediate film:

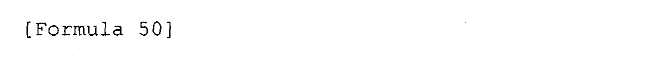

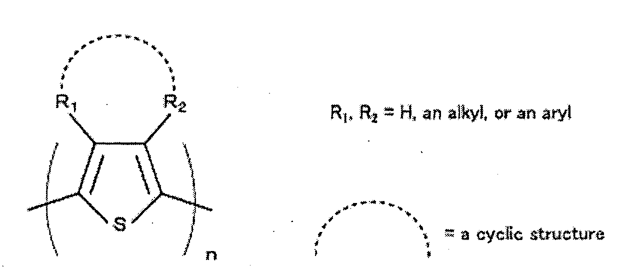

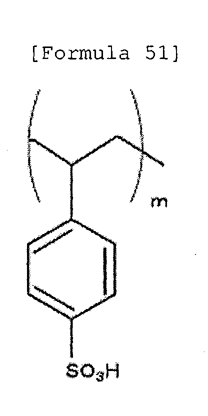

The above-described matters relevant to the eighth and the ninth inventions are also the same in the tenth to the thirteenth inventions if they are in the scope of the appended claims. The electronic apparatus includes a variety of semiconductor devices comprising semiconductor electrodes composed of semiconductor fine particles other than the photoelectric conversion device.

According to the inventions constituted as described above, since an intermediate film comprising polythiophene, its derivatives as well as polystyrenesulfonic acid and the like is formed on a metal oxide film and then a semiconductor fine particle layer such as a titanium oxide fine particle layer is formed on the intermediate film, the adhesion property of the intermediate film to the metal oxide film and the adhesion property of the semiconductor fine particle layer to the intermediate film are both extremely good and therefore, as compared with that in the case of forming the semiconductor fine particle layer directly on the metal oxide film, the adhesion property of the semiconductor fine particle layer can remarkably be improved. Further, in the case of forming the semiconductor fine particle layer on a metal oxide film by using a strongly acidic semiconductor fine particle dispersion, the intermediate film works as a protection layer to the strong acid, so that elution of the metal oxide film can be prevented. Further, since the intermediate film is made of a conductive polymer and therefore has conductivity, the film can keep good electric communication between the semiconductor electrode and the metal oxide film.

### BRIEF DESCRIPTION OF THE INVENTION

Fig.1 is a cross-sectional view illustrating a dye-sensitized type wet solar cell fabrication method according to one embodiment of the invention;
Fig.2 is a cross-sectional view illustrating a dye-sensitized type wet solar cell fabrication method according to an embodiment of the invention;
Fig.3 is a cross-sectional view illustrating a dye-sensitized type wet solar cell fabrication method according to an embodiment of the invention;
Fig.4 is a cross-sectional view illustrating a dye-sensitized type wet solar cell fabrication method according to an embodiment of the invention;
Fig.5 is a cross-sectional view illustrating a dye-sensitized type wet solar cell fabrication method according to an embodiment of the invention;
Fig.6 is a cross-sectional view illustrating a dye-sensitized type wet solar cell fabrication method according to an embodiment of the invention;
Fig. 7 is a photograph in place of a drawing for showing the results of a rubbing test of a platinum film in a dye-sensitized type wet solar cell according to an embodiment of the invention;
Fig. 8 is a photograph in place of a drawing for showing the results of a rubbing test of a platinum film in a dye-sensitized type wet solar cell according to an embodiment of the invention;
Fig.9 is a cross-sectional view illustrating a dye-sensitized type wet solar cell fabrication method according to an embodiment of the invention;
Fig. 10 is a cross-sectional view illustrating a dye-sensitized type wet solar cell fabrication method according to an embodiment of the invention;
Fig. 11 is a cross-sectional view illustrating a dye-sensitized type wet solar cell fabrication method according to an embodiment of the invention;
Fig. 12 is a cross-sectional view illustrating a dye-sensitized type wet solar cell fabrication method according to an embodiment of the invention;
Fig. 13 is a cross-sectional view illustrating a dye-sensitized type wet solar cell fabrication method according to an embodiment of the invention;
Fig. 14 is a cross-sectional view illustrating the operation of a dye-sensitized type wet solar cell according to an embodiment of the invention; and
Fig. 15 is an approximate line showing the measurement results of properties of a dye-sensitized type wet solar cell according to an embodiment of the invention.

### DETAILED DESCRIPTION OF THE INVENTION

Hereinafter, an embodiment of the invention will be described with reference to drawings. In the entire drawings of the embodiment, a single sign is assigned for the same parts or corresponding parts.

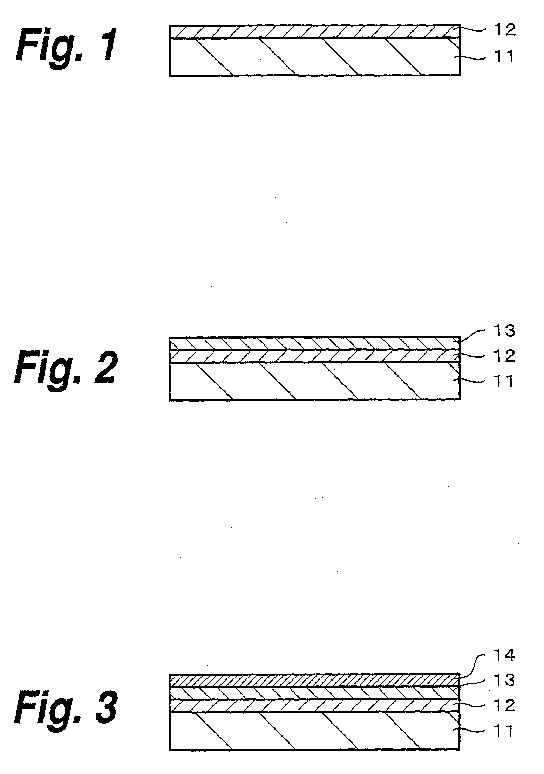

Fig. 1 to Fig. 5 show a dye-sensitized type wet solar cell fabrication method according to an embodiment of the invention.

In this embodiment, at first, as shown in Fig. 1, a transparent substrate 11 on which a transparent electrode 12 of a metal oxide such as ITO is formed is made ready.

Next, as shown in Fig. 2, a PEDOT/PSS film 13 is formed on the transparent electrode 12. The thickness of the PEDOT/PSS film 13 is adjusted to be, for example, 30 to 400 nm. To form the PEDOT/PSS film 13, an aqueous PEDOT/PSS solution is spin-coated to the transparent electrode 12 and hardened by heating and evaporating water.

Next, as shown in Fig. 3, a platinum film 14 as an opposite electrode is formed on the PEDOT/PSS film 13.

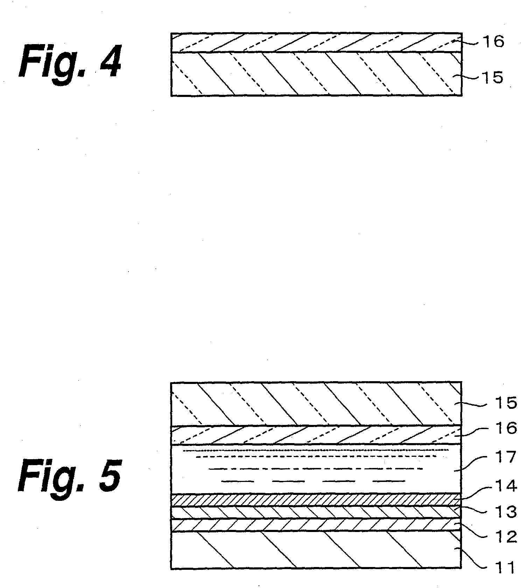

On the other hand, as shown in Fig. 4, a transparent conductive substrate 15 is made ready and a semiconductor fine particle layer 16 carrying a sensitizing dye is formed thereon. The sensitizing dye-carrying semiconductor fine particle layer 16 may be formed as follows, for example. That is, at first, a colloidal solution containing semiconductor fine particles is applied to the transparent conductive substrate by spin coating and the solvent is evaporated and dried out by heating at a temperature not higher than the heat resistant temperature of the transparent conductive substrate 15. Accordingly, the semiconductor fine particle layer 16 is formed. After that, the dye is deposited by, for example, immersing the semiconductor fine particle layer 16 in a solution of the dye.

Next, as shown in Fig. 5, the transparent substrate 11 on which the transparent electrode 12, the PEDOT/PSS film 13, and the platinum film 14 are formed and the transparent conductive substrate 15 on which the semiconductor fine particle layer 16 is formed are set face to face each other at a prescribed gap between the platinum film 14 and semiconductor fine particle layer 16 so as to keep a space in which an electrolytic layer is sealed by using a prescribed sealing material and in the space, an electrolytic layer 17 is injected through an injection port formed previously in the space. After that, the injection port is closed. Accordingly, the dye-sensitized wet type solar cell is fabricated.

Next, the operation of the dye-sensitized wet type solar cell will be described.

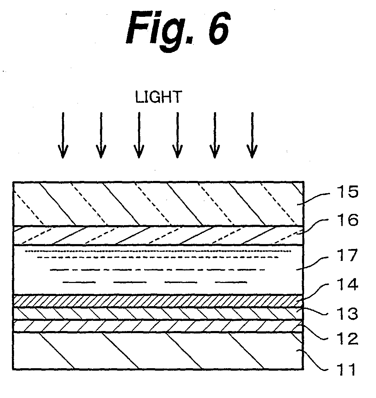

As shown in Fig. 6, light coming in through the transparent conductive substrate 15 from the transparent conductive substrate 15 side excites the sensitizing dye deposited on the surface of the semiconductor fine particle layer 16 to generate electrons. The electrons are quickly transmitted to the semiconductor fine particles of the semiconductor fine particle layer 16 from the sensitizing dye. On the other hand, the sensitizing dye which loses the electrons receives electrons from the ion of the electrolytic layer 16 and the ion which gives electrons receives electrons again in the platinum film 14, an opposite electrode. According to a series of the steps, electric motive force is generated between the transparent conductive substrate 15 electrically connected with the semiconductor fine particle layer 16 and the transparent electrode 12 electrically connected with the platinum film 14 through the PEDOT/PSS film 13. In such a manner, photoelectric conversion is carried out.

As described above, according to this embodiment, after the PEDOT/PSS film 13 is formed at first on transparent electrode 12 made of a metal oxide such as ITO, the platinum film 14 is formed thereon as an opposite electrode, so that as compared with the case the platinum film 14 is formed directly on the transparent electrode 12, the adhesion property of the platinum film 14 is remarkably improved and therefore, the platinum film 14 is extremely hardly peeled. Accordingly, the durability of the platinum film 14 as an opposite electrode is remarkably improved and subsequently, the reliability, durability, and life of the dye-sensitized wet type solar cell are remarkably improved. Further, since the undercoat of the platinum film 14 is the PEDOT/PSS film 13, there occurs no pollution with a different type metal, the platinum film 14. Additionally, since the PEDOT/PSS film 13 is a conductive polymer, the electric contact between the transparent electrode 12 and the platinum film 14 can be kept well and thus the dye-sensitized wet type solar cell can be operated well. Further, the PEDOT/PSS film 13 can easily be formed by a spin coating method.

### [Examples]

### Example 1

An example of a dye-sensitized wet type solar cell fabrication method will be described.

At first, as a transparent substrate 11 and transparent electrode 12, a polyethylene terephthalate (PET) film with 120 µm thickness and coated with an ITO film with a 300 nm thickness by vacuum deposition was made ready. The ITO-coated PET film was cut into 25 mm square size.

Next, the surface of the transparent electrode 12 of the ITO film was washed with pure water and then isopropanol under ultrasonic wave application for degreasing and dried in nitrogen current.

Next, an aqueous solution of 1. 3 wt% of PEDOT/PSS was applied to the transparent electrode 12 of the ITO film by spin-coating at 3,000 rpm and dried on a hot plate heated to 120°C to form a PEDOT/PSS film 13.

After that, a platinum film 14 was formed on the PEDOT/PSS film 13 by a sputtering method. The thickness of the platinum film 14 was adjusted to be 40 nm.

On the other hand, to a titanium oxide colloidal solution (100 mL) with 10% titanium oxide concentration, an anatase type titanium oxide powder in an equimolecular amount with titanium oxide in the solution was added and together with 100 g of zirconia beads, the resulting solution was loaded into a zirconia pot with 250 mL capacity and dispersed for 3 hours by a planetary ball mill. After that, the beads are removed from the obtained solution by filtration to obtain a white titanium oxide dispersion. Next, as a transparent conductive substrate 15, a polyethylene terephthalate (PET) film with 120 µm thickness and coated with an ITO film with a 300 nm thickness by vacuum deposition was made ready. The ITO-coated PET film was cut into 25 mm square size. Next, the surface of the ITO film was washed with pure water and then isopropanol under ultrasonic wave application for degreasing and dried in nitrogen current.

Next, the ITO film was coated with one layer of a titanium oxide colloidal solution containing 10% of titanium oxide by spin coating and successively 3 layers were formed by spin-coating using the titanium oxide dispersion obtained in the above-mentioned manner. After that, the resulting PET film coated by spin-coating was set on a hot plate heated to 120°C and dried for 30 minutes. In such a manner, a semiconductor fine particle layer 16 composed of titanium oxide fine particles was formed. The thickness of the formed semiconductor fine particle layer 16 was about 3 to 5 µm.

The PET film coated with the semiconductor fine particle layer 16 composed of titanium oxide fine particles was then immersed in an ethanol solution of a ruthenium dye [ruthenium dye (0.5 mM) : deoxycolic acid (20 mM) ] overnight to deposit the sensitizing dye on the semiconductor fine particle layer 16 and then the film was taken out of the solution and rinsed with ethanol and immediately used for solar cell assembly. The solar cell assembly was carried out by the following procedure. At first, the transparent substrate 11 coated with the platinum film 14 and the transparent conductive substrate 15 coated with the semiconductor fine particle layer 16 composed of titanium oxide fine particles were held in such a manner that the platinum film 14 and the semiconductor fine particle layer 16 were kept on the opposite to each other while sandwiching a U-shaped spacer (0.3 mm thickness) made of polytetrafluoroethylene and having a 5 mm width and the outer circumference of them was sealed with a 30 µm-thick EVA film and an epoxy resin to form a space into which an electrolytic layer was to be injected. Next, an electrolytic layer 17 was injected through an injection port previously formed in the space. As the electrolytic layer 17, a propylene carbonate/ethylene carbonate (1/1) solution containing LiI (0.5 M), iodine (0.05 M), and tert-butylpyridine (0.5 M) was used. After that, the injection port was closed. As described, a dye-sensitized wet type solar cell was obtained.

On the other hand, as Comparative Example, a dye-sensitized wet type solar cell was fabricated in the same manner as the above-mentioned Example, except that the platinum film 14 was formed directly on the transparent electrode 12.

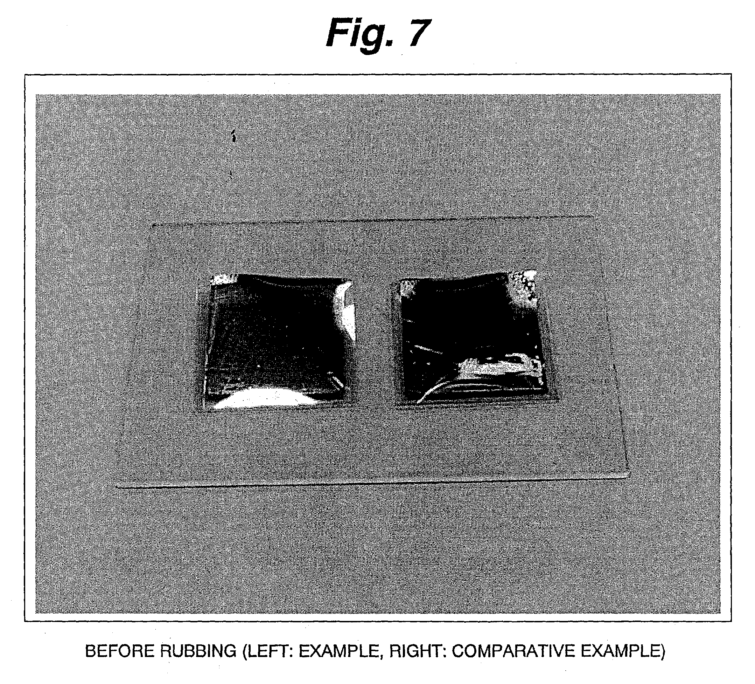

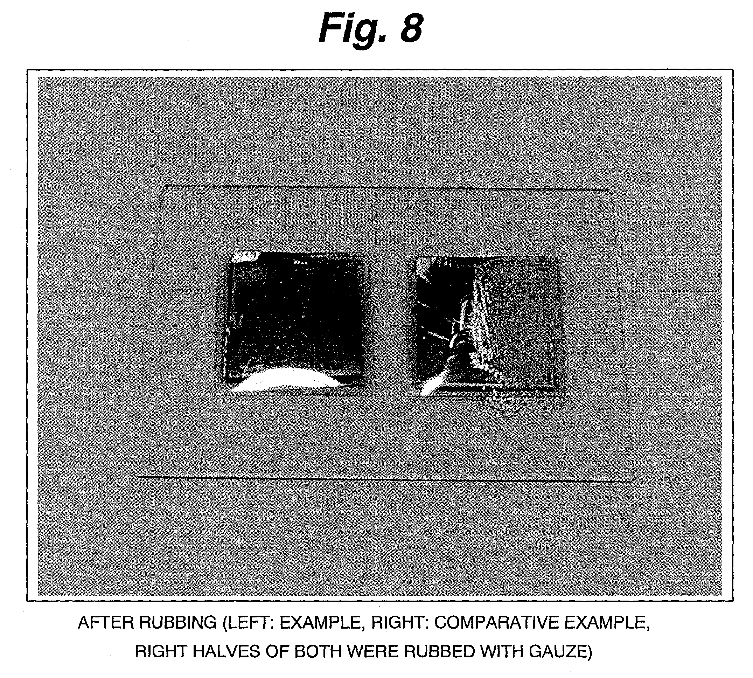

The platinum film 14 formed on the transparent electrode 12 of the ITO film through the PEDOT/PSS film 13 as Example and the platinum film 14 formed directly on the transparent electrode 12 as Comparative Example were subjected to a rubbing test. The rubbing test was carried out by wrapping a finger with gauze and reciprocating the finger with a prescribed force on the platinum films 14 to evaluate the occurrence of peeling. Fig. 7 and Fig. 8 show photographs of the respective platinum films 14 before and after the rubbing test. The samples in the left side in the respective Figs. are of Example and the samples in the right side are of Comparative Example. As being understood by comparison of Fig. 7 and Fig. 8, the platinum film 14 of Comparative Example was completely peeled off, meanwhile the platinum film 14 of Example was not peeled although scratches were observed slightly.

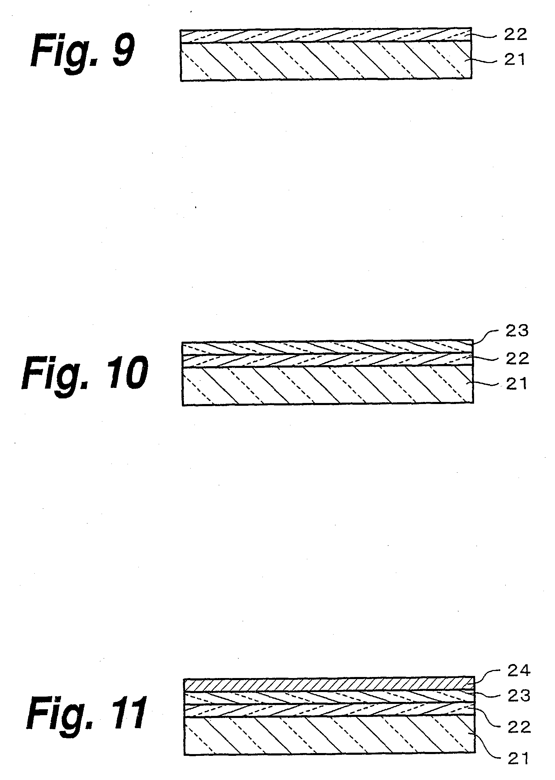

Fig. 9 to Fig. 13 show a dye-sensitized wet type solar cell fabrication method of another embodiment of the invention.

In this embodiment, at first, as shown in Fig. 9, a transparent substrate 21 on which a transparent electrode 22 of a metal oxide such as ITO is formed is made ready.

Next, as shown in Fig. 10, a PEDOT/PSS film 23 is formed on the transparent electrode 22. The thickness of the PEDOT/PSS film 23 is adjusted to be, for example, 30 to 400 nm. To form the PEDOT/PSS film23, an aqueous PEDOT/PSS solution is spin-coated to the transparent electrode 22 and hardened by heating and evaporating water.

Next, as shown in Fig. 11, a semiconductor fine particle layer 24 carrying a sensitizing dye is formed on the PEDOT/PSS film 23. The semiconductor fine particle layer 24 carrying the sensitizing dye was formed as follows, for example. That is, a colloidal solution containing semiconductor fine particles was applied by spin coating and then the formed coating was heated at a temperature not higher than the heat resistant temperature of the transparent substrate 21, for example 100 to 140°C, to evaporate the solvent and dry the coating. Accordingly, the semiconductor fine particle layer 24 was formed. After that, a dye was deposited on the semiconductor fine particle layer 24 by immersing the layer in a dye solution or the like.

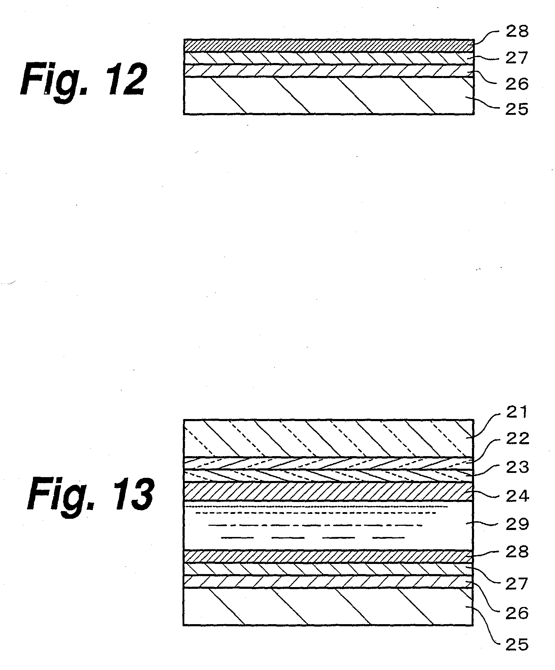

On the other hand, as shown in Fig. 12, a transparent substrate 25 coated with a transparent electrode 26 made of a metal oxide such as ITO is made ready and a PEDOT/PSS film 27 is formed on the transparent electrode 26 in the same manner as described above. The thickness of the PEDOT/PSS film 27 is adjusted to be, for example, 30 to 400 nm. After that, a platinum film 28 as an opposite electrode is formed on the PEDOT/PSS film 27.

Next, as shown in Fig. 13, the transparent substrate 21 on which the transparent electrode 22, the PEDOT/PSS film 23, and the semiconductor fine particle layer 24 are formed and the transparent substrate 25 on which the transparent electrode 26, the PEDOT/PSS film 27, and the platinum film 28 are formed are set face to face each other in such a manner that a prescribed gap is kept between the semiconductor fine particle layer 24 and the platinum film 28 so as to keep a space in which an electrolytic layer is to be sealed by using a prescribed sealing material and in the space, an electrolytic layer 29 is injected through an injection port formed previously in the space. After that, the injection port is closed. Accordingly, the dye-sensitized wet type solar cell is fabricated.

Next, the operation of the dye-sensitized wet type solar cell will be described.

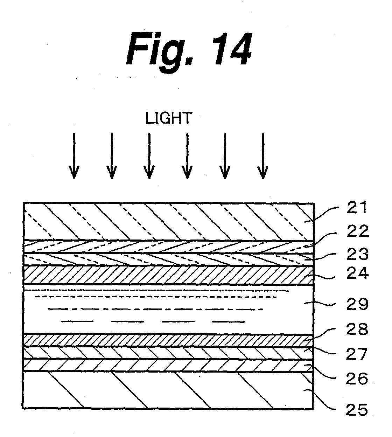

As shown in Fig. 14, light coming in through the transparent substrate 21 from the transparent substrate 21 side excites the sensitizing dye deposited on the surface of the semiconductor fine particle layer 24 to generate electrons. The electrons are quickly transmitted to the semiconductor fine particles of the semiconductor fine particle layer 24 from the sensitizing dye. On the other hand, the sensitizing dye which loses the electrons receives electrons from the ion of the electrolytic layer 29 and the ion which gives electrons receives electrons again in the platinum film 28, an opposite electrode. According to a series of the steps, electric motive force is generated between the transparent electrode 22 electrically connected with the semiconductor fine particle layer 24 through the PEDOT/PSS film 23 and the platinum film 28. In such a manner, photoelectric conversion is carried out.

As described above, according to this embodiment, after the PEDOT/PSS film 23 is formed at first on transparent electrode 22 made of a metal oxide such as ITO, the semiconductor fine particle layer 24 is formed thereon by using a semiconductor fine particles dispersion, so that as compared with the case the semiconductor fine particle layer 24 is formed directly on the transparent electrode 22, the adhesion property of the semiconductor fine particle layer 24 is remarkably improved and therefore, the semiconductor fine particle layer 24 is extremely hardly peeled and cracked. Further, in the case the semiconductor fine particle layer 24 is formed using a strongly acidic semiconductor fine particle dispersion, the PEDOT/PSS film 23 works as a protection layer for the transparent electrode 22, so that elution of the transparent electrode 22 by strong acid can be prevented. Further, in the case the semiconductor fine particle layer 24 is, for example, a titanium oxide fine particle layer, on one hand, titanium oxide is an n-type semiconductor, on the other hand, the PEDOT/PSS film 23 is a p-type semiconductor and in terms of such facts, the insertion of the PEDOT/PSS film 23 between the transparent electrode 22 and the semiconductor fine particle layer 24 is supposed to be disadvantageous from a viewpoint of energy diagram, however according to experiment results, insertion of the PEDOT/PSS film 23, on the contrary, gives good electric communication between the transparent electrode 22 and the semiconductor fine particle layer 24 to result in remarkable photoelectric conversion of the dye-sensitized wet type solar cell. Further, the PEDOT/PSS film 23 can be formed easily by low temperature process by the above-mentioned spin coating or roller coating method.

Also, in this embodiment, with respect to the opposite electrode, since the platinum film 28 as the opposite electrode is formed after the PEDOT/PSS film 27 is at first formed on the transparent electrode 26 of a metal oxide such as ITO, as compared with the case the platinum film 28 is directly formed on the transparent electrode 26, the adhesion property of the platinum film 28 is remarkably improved and accordingly the platinum film 28 is extremely hardly peeled off and therefore, the durability of the platinum film 28 as the opposite electrode is remarkably improved and subsequently, the reliability, durability, and life of the dye-sensitizedwettypesolarcellareremarkablyimproved. Further, since the undercoat of the platinum film 28 is the PEDOT/PSS film 27, there occurs no pollution with a different type metal, the platinum film 28. Additionally, since the PEDOT/PSS film 27 is a conductive polymer, the electric contact between the transparent electrode 26 and the platinum film 28 can be kept well and thus the dye-sensitized wet type solar cell can be operated well.

Further, use of flexible, transparent, and plastic substrates of such as polyethyleneterephthalate (PET) films for the transparent electrode 21 and 25 makes it possible to obtain a flexible dye-sensitized wet type solar cell and consequently, the dye-sensitized wet type solar cell can be made portable, usable in a widened range of use, e.g. simply sticking it to a window or a wall, and so remarkably convenient.

### [Examples]

Examples of dye-sensitized wet type solar cell fabrication methods will be described.

### Example 2

At first, as a transparent substrate 21 and transparent electrode 22, a polyethylene terephthalate (PET) film with 120 µm thickness and coated with an ITO film with a 300 nm thickness by vacuum deposition was made ready. The ITO-coated PET film had a sheet resistance of 10 to 30 Ω/□. The ITO-coated PET film was cut into 25 mm square size.

Next, the surface of the transparent electrode 22 of the ITO film was washed with pure water and then isopropanol under ultrasonic wave application for 15 minutes for degreasing and dried in nitrogen current.

Next, a PEDOT/PSS film 23 was formed on the transparent electrode 22, which was the ITO film, as follows. At first, the transparent substrate 21 coated with the transparent electrode 22, that is the ITO-coated PET film, was fixed on a glass substrate and being united with the glass substrate, the transparent substrate 21 was set in a spin coater. Next, an aqueous solution of 1.3 wt% of PEDOT/PSS was spread on the ITO-coated PET film and applied by spin-coating at 500 rpm for initial 5 seconds and 5,000 rpm for next 30 seconds. After the spin-coating, the ITO-coated PET film was set on a hot plate heated to 120°C and dried in such a state for 30 minutes. Incidentally, although it is reported that if ITO is left for a long time while being wetted with an aqueous PEDOT/PSS solution, ITO is eroded by the acidity of the aqueous PEDOT/PSS solution and indium is diffused in the PEDOT/PSS in Appl. Phys. Lett. 77 (2000) 2255, here it was confirmed that the transparent electrode 22 of ITO was not so much changed based on the electric conductivity measurement.

After the drying, as a first layer, a toluene solution containing 2% Ti (O-iPr) was applied by spin-coating in the same conditions as those of the aqueous PEDOT/PSS solution and subjected to drying at 120°C for 30 minutes. Successively, a titanium oxide colloidal solution with a titanium oxide concentration adjusted to be 10% was obtained by a method described in Langmuir, 16 (2000) 5625 was applied by spin coating and subjected to drying at 120°C for 30 minutes repeatedly 5 times. In such a manner, a semiconductor fine particle layer 24 composed of titanium oxide fine particles was formed. The thickness of the formed semiconductor fine particle layer 24 was about 3 to 5 µm.

On the other hand, as a transparent substrate 25 and a transparent electrode 26, a PET film with 120 µm thickness and coated with an ITO film with a 300 nm thickness by vacuum deposition was made ready. The ITO-coated PET film had a sheet resistance of 10 to 30 Ω/□. The ITO-coated PET film was cut into 25 mm square size. Next, the surface of the ITO film was washed with pure water and then isopropanol under ultrasonic wave application for 15 minutes for degreasing and dried in nitrogen current.

Next, a PEDOT/PSS film 27 was formed on a transparent electrode 26, which was the ITO film, in the same manner as described above.

Next, a platinum film 28 was formed on the PEDOT/PSS film 27 by a sputtering method. The thickness of the platinum film 28 was adjusted to be 40 nm.

Next, the PET film coated with the semiconductor fine particle layer 24 composed of titanium oxide fine particles was immersed in an ethanol solution [ruthenium dye (0.5 mM) : doexycolic acid (20 mM)] of a ruthenium dye [Ruthenium (2,2'-bipyridyl-4,4'-dicarboxylate)₂(NCS)₂] overnight to deposit the sensitizing dye on the semiconductor fine particle layer 24 and then the resulting film was taken out of the solution and rinsed with ethanol and immediately used for solar cell assembly.

The solar cell assembly was carried out by the following procedure. At first, the transparent substrate 25 coated with the platinum film 28 and the transparent conductive substrate 21 coated with the semiconductor fine particle layer 24 composed of titanium oxide fine particles were held in such a manner that the platinum film 28 and the semiconductor fine particle layer 24 were kept on the opposite to each other while sandwiching a U-shaped spacer (0.3mm thickness) made of polytetrafluoroethylene and having a 5 mm width and the outer circumference of them was sealed with a 30 µm-thick EVA film and an epoxy resin to form a space into which an electrolytic layer was to be injected. Next, an electrolytic layer 29 was injected through an injection port previously formed in the space. As the electrolytic layer 29, a propylene carbonate/ethylene carbonate (1/1) solution containing LiI (0.5 M), iodine (0.05 M), and tert-butylpyridine (0.5 M) was used. After that, the injection port was closed. As described, a dye-sensitized wet type solar cell was obtained.

### Example 3

In Example 3, a dye-sensitized wet type solar cell was fabricated in the same manner as Example 2, except that a semiconductor fine particle layer 24 composed of titanium oxide fine particles was formed in the following manner.

That is, in Example 3, at first to a titanium oxide colloidal solution (100 mL) adjusted to have a titanium oxide concentration to be 10% and obtained by the method described in Langmuir, 16 (2000) 5625, an anatase type titanium oxide powder with a larger particle size in an amount equivalent to that of the titanium oxide in the colloidal solution was added and together with zirconia beads, the resulting solution was loaded into a zirconia pot with 250 mL capacity and dispersed for 3 hours by a planetary ball mill. After that, the beads are removed from the obtained solution by filtration to obtain a white titanium oxide dispersion.

After the titanium oxide colloidal solution adjusted to have a titanium oxide concentration to be 10% was applied in one layer to the PEDOT/PSS film 23, 3 layers of the spin-coating using the titanium oxide dispersion obtained in the above-mentioned manner were formed by spin coating the titanium oxide dispersion. Every time after the spin coating, the formed coating was subjected to heating at 220°C for 30 minutes for drying.

### Comparative Example 1

In Comparative Example 1, a dye-sensitized wet type solar cell was fabricated in the same manner as Example 2, except that a semiconductor fine particle layer 24 composed of titanium oxide fine particles was formed on the transparent electrode 22 without forming the PEDOT/PSS film 23 and the platinum film 28 was formed on the transparent electrode 26 without forming the PEDOT/PSS film 27.

### Comparative Example 2

In Comparative Example 2, a dye-sensitized wet type solar cell was fabricated in the same manner as Example 2, except that a semiconductor fine particle layer 24 composed of titanium oxide fine particles was formed directly on the transparent electrode 22 using a commercialized anatase type titanium oxide according to the method described in Chem. Lett. 12 (2002) 1250 and the platinum film 28 was formed on the transparent electrode 26 without forming the PEDOT/PSS film 27.

With respect to solar cells of Examples 2 and 3 and Comparative Examples 1 and 2, the semiconductor fine particle layers 24 composed of the titanium oxide fine particles were observed and found that the semiconductor fine particle layer 24 formed without forming the PEDOT/PSS film 23 was cracked in the entire surface and partially peeled off in the solar cell sample of Comparative Example 1, meanwhile the semiconductor fine particle layers 24 formed after formation of the PEDOT/PSS films 23 were neither cracked nor peeled and thus excellent in the solar cell samples of Examples 2 and 3. In the solar cell sample of Comparative Example 2 in which the semiconductor fine particle layer 24 was formed by electrodeposition, a white film-like semiconductor fine particle layer 24 was obtained and the quality and the adhesion property of the film were good. In the solar cell samples of Examples 2 and 3 in which the platinum films 28 were formed after formation of the PEDOT/PSS films 23, the platinum films 28 were not peeled off.

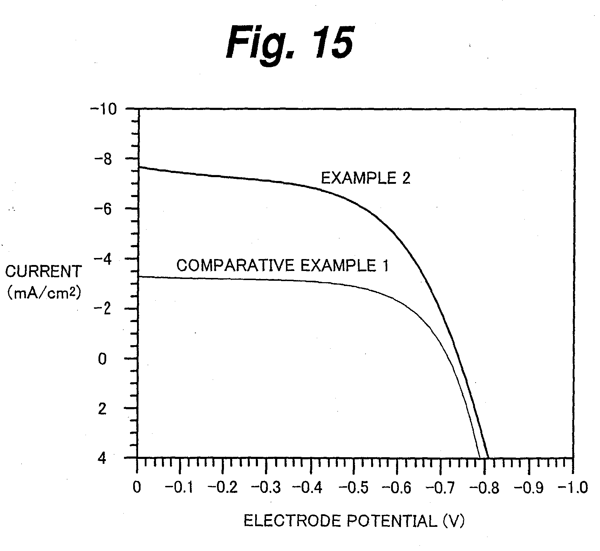

Fig. 15 and Table 1 show the results of the evaluation of the properties and characteristics of the solar cells of Example 1 and Comparative Examples 1 and 2. The evaluation was carried out by using, as a light source, a solar simulator (USHIO Optical Modulex, 500 W xenon short arc lamp, AM 1.5 (83.2 mW/cm²).

**Table 1**

| Example 2 | Example 1 | Comparative |
|---|---|---|
| Electrodeposition | Spin | coating |
| open-circuit voltage [mV] | 740 | 720 |
| short-circuit current density [mA/cm²] | 8.0 | 3.0 |
| fill factor [%] | 56.8 | 60.5 |
| photoelectric conversion efficiency [%] | 3.9 | 1.6 |

From the results shown in Fig. 15 and Table 1, it is clearly understood that the solar cell of Example 2 has better solar cell characteristics than those of the solar cell of Comparative Example 1 and remarkably better open circuit voltage, short-circuit current density, and photoelectric conversion efficiency than those of the solar cell of Comparative Example 2 and approximately same fill factor as that of the solar cell of Comparative Example 2.

With respect to the solar cell of Example 3, further excellent solar cell characteristics as compared with those of Example 2 were obtained. That is supposedly attributed to that the semiconductor fine particle layer 24 was formed by using a semiconductor fine particle dispersion with a high particle concentration by additionally dispersing anatase type titanium oxide powder with a larger particle size than that of the titanium oxide contained in the titanium oxide colloidal solution and therefore the semiconductor fine particle layer 24 was made porous as compared with the semiconductor fine particle layer 24 formed by using a semiconductor fine particle dispersion in which no anatase type titanium oxide powder was dispersed.

While the invention has been described with reference to specific embodiments and examples, the description is illustrative of the invention and is not to be construed as limiting the invention. Various modifications and applications may occur to those skilled in the art without departing from the true spirit and scope of the invention as defined by the appended claims.

For example, the values, structures, shapes, materials, raw materials, and processes described in the embodiments and examples are only illustrative and different values, structures, shaped, materials, raw materials and processes may be used based on necessity.

Practically, for example, in the above-mentioned embodiments and examples, the dye is deposited on semiconductor fine particles by immersion of the particles in the dye solution after the semiconductor fine particle layer 14 is formed, however a paste containing semiconductor fine particles previously coated with the dye may be applied.

## Claims

1. A method of fabricating a photoelectric conversion device comprising a semiconductor electrode and a metal film to be an opposite electrode formed on a metal oxide film, wherein the method includes steps of
(i) forming on the metal oxide film an intermediate film comprising a compound which is a polythiophene defined by the following Formula 1 or derivative thereof and at least one compound which is a polystyrene sulfonic acid defined by the following Formula 2, RSO₃H (where R is an alkyl or aryl group), R'OSO₃H (where R' is H, or an alkyl, or aryl group), HCl, HClO₄, HPF₆, HBF₄, or HI₅ and
(ii) forming the metal film on the intermediate film:

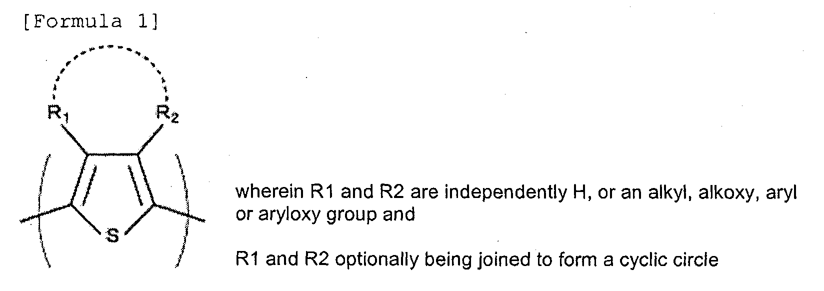

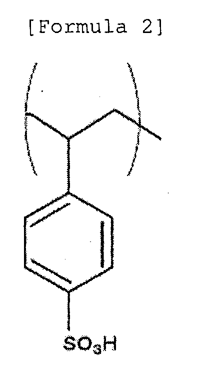

2. The method of claim 1, wherein the intermediate film is composed of polyethylene dioxythiophene defined by the following Formula 3 and polystyrenesulfonic acid defined by the following Formula 4:

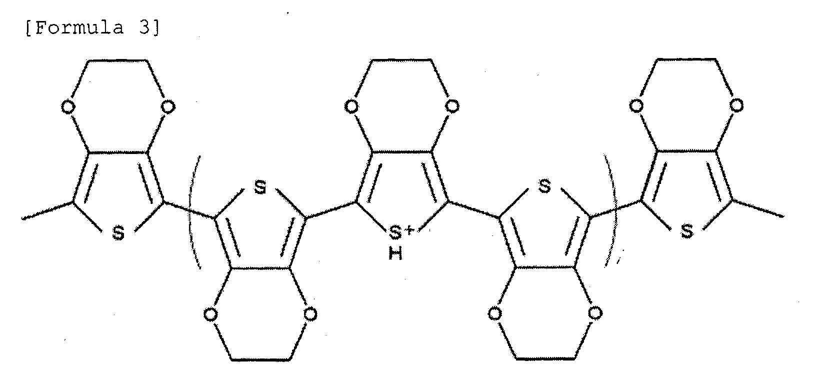

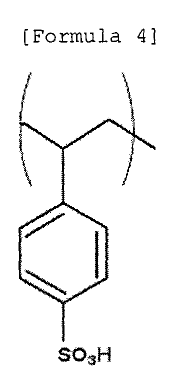

3. The method of claim 1, wherein the intermediate film is formed by using an aqueous solution containing polyethylene dioxythiophene defined by the following Formula 5, polystyrenesulfonic acid ion defined by the following Formula 6, and polystyrenesulfonic acid defined by the following Formula 7:

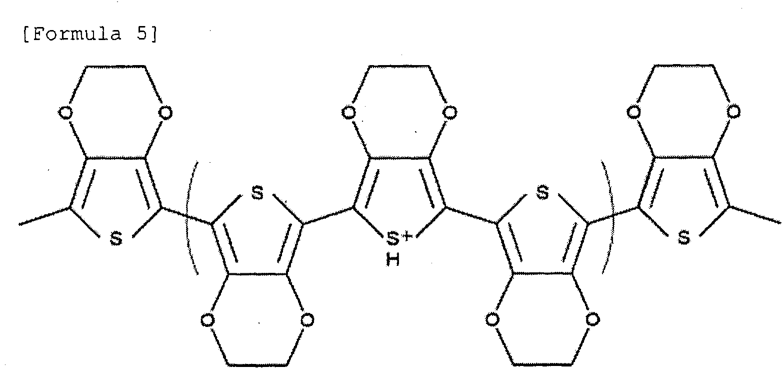

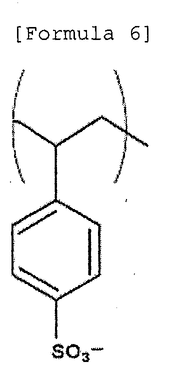

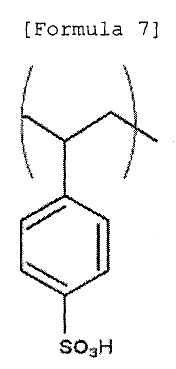

4. The method of any one of the preceding claims, wherein the metal oxide film is made of at least one metal oxide selected from In-Sn oxide, SnO₂, TiO₂, and ZnO.

5. The method of any one of the preceding claims, wherein the metal film is made of at least one metal selected from platinum, gold, aluminum, copper, silver and titanium.

6. The method of any one of claims 1 to 4, wherein the metal film is a monolayer film or a multilayer film made of at least one metal selected from platinum, gold, aluminum, copper, silver and titanium.

7. The method of any one of the preceding claims, wherein the semiconductor electrode is composed of semiconductor fine particles.

8. The method of fabricating a photoelectric conversion device as claimed in any one of the preceding claims, wherein the photoelectric conversion device is a wet type solar cell.

9. A photoelectric conversion device comprising a semiconductor electrode and a metal film to be an opposite electrode formed on a metal oxide film, wherein on the metal oxide film is formed an intermediate film comprising a compound which is a polythiophene defined by the following Formula 8 or derivative thereof and at least one compound which is a polystyrenesulfonic acid defined by the following Formula 9, RSO₃H (where R is an alkyl or aryl group) , R' OSO₃H (where R' is H, or an alkyl or aryl group) , HCl, HClO₄, HPF₆, HBF₄, or HI₅ and the metal film is formed on the intermediate film:

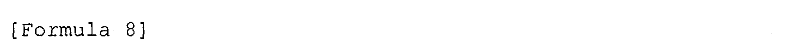

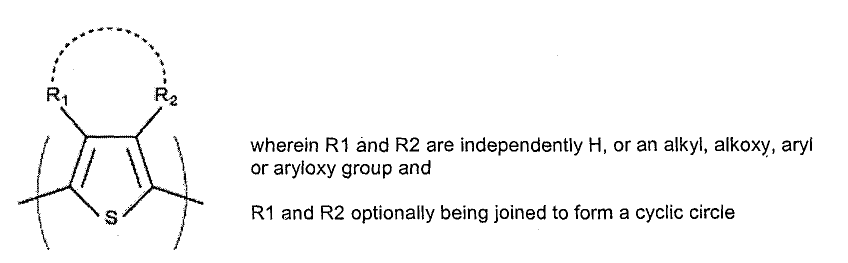

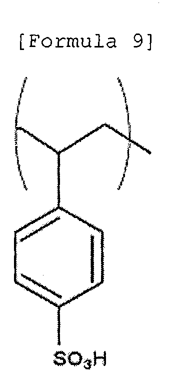

10. A method of manufacturing an electronic apparatus comprising a metal film formed on a metal oxide film wherein the method includes steps of forming on the metal oxide an intermediate film as defined in any one of claims 1 to 3.

11. An electronic apparatus comprising a metal film formed on a metal oxide film wherein on the metal oxide film is formed an intermediate film as defined in any one of claims 1 to 3.

12. A metal film formation method for forming a metal film on a metal oxide film, wherein the method includes the steps of forming on the metal oxide film an intermediate film as defined in any one of claims 1 to 3 and forming the metal film on the intermediate film.

13. A layer structure comprising a metal film formed on a metal oxide film, wherein on the metal oxide film is formed as defined in any one of claims 1 to 3.

14. A method of fabricating a photoelectric conversion device comprising a semiconductor electrode composed of semiconductor fine particles on a metal oxide film, wherein the method includes steps of forming on the metal oxide film an intermediate film as defined in any one of claims 1 to 3 and forming the semiconductor electrode on the intermediate film.

15. The method of claim 14, wherein the metal oxide film is made of at least one metal oxide selected from In-Sn oxide, SnO₂, TiO₂, and ZnO.

16. The method of claim 14, wherein the metal oxide film is formed on a transparent plastic substrate.

17. The method of claim 14, wherein the semiconductor electrode is formed by using a strongly acidic semiconductor fine particle dispersion.

18. The method of claim 14, wherein the semiconductor electrode is formed at a temperature not lower than 100°C and not higher than 140°C.

19. The method of claim 14, wherein the photoelectric conversion device is a wet type solar cell.

20. A photoelectric conversion device comprising a semiconductor electrode composed of semiconductor fine particles on a metal oxide film wherein on the metal oxide film is formed an intermediate film as defined in any one of claims 1 to 3 and the semi conductor electrode is formed on the intermediate film.

21. A method of manufacturing an electronic apparatus comprising a semiconductor electrode composed of semiconductor fine particles on a metal oxide film wherein the method includes the steps of forming on the metal oxide film an intermediate film as defined in any one of claims 1 to 3, and forming the semiconductor electrode on the intermediate film.

22. An electronic apparatus comprising a semiconductor electrode composed of semiconductor fine particles on a metal oxide film wherein on the metal oxide film is formed an intermediate film as defined in any one of claims 1 to 3, and the semiconductor electrode is formed on the intermediate film.

23. A semiconductor fine particle layer formation method for forming a semiconductor fine particle layer on a metal oxide film wherein the method includes the steps of forming on the metal oxide film an intermediate film as defined in any one of claims 1 to 3, and forming the semiconductor fine particle layer on the intermediate film.

24. A layer structure comprising a semiconductor fine particle layer on a metal oxide film wherein on the metal oxide film is formed an intermediate film as defined in any one of claims 1 to 3, and the semiconductor fine particle layer is formed on the intermediate film.
